# EUROPEAN PATENT APPLICATION

(11) **EP 4 485 078 A1**
(43) Date of publication of application: **01.01.2025**
(21) Application number: 24179866.9
(22) Date of filing: 04.06.2024
(51) Int. Cl.: G03F 7/09, G03F 7/11

(54) **COMPOSITION FOR FORMING ORGANIC FILM, METHOD FOR FORMING ORGANIC FILM, AND PATTERNING PROCESS**

(30) Priority: 20.06.2023 JP 2023100689
(71) Applicant: SHIN-ETSU CHEMICAL CO., LTD., Tokyo 1000005 (JP)
(72) Inventor: Kori, Daisuke, Niigata (JP); Yamamoto, Yasuyuki, Niigata (JP); Imata, Tomohiro, Niihata (JP)
(74) Representative: Sonnenhauser, Thomas Martin

(57) **Abstract**

The present invention is a composition for forming an organic film, containing: (A) a polymer having a repeating unit represented by the following general formula (1); (B) a resin for forming an organic film; and (C) a solvent, where R in the general formula (1) represents a saturated or unsaturated divalent organic group having 2 to 30 carbon atoms. This provides: a composition for forming an organic film which is excellent in film-formability (in-plane uniformity) on a substrate (wafer) and filling property and in which humps in an EBR process are suppressed; a method for forming an organic film, using the composition; and a patterning process.

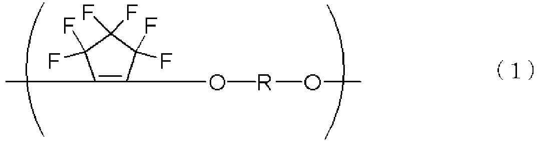

## Description

### TECHNICAL FIELD

The present invention relates to: a composition for forming an organic film; a method for forming an organic film by using the composition; and a patterning process using the composition.

### BACKGROUND ART

Recently, along with advancements toward higher integration and higher processing speed of semiconductor devices, a finer pattern rule has been required. In this situation, various techniques have been developed in regard to how patterning process can be performed more finely and precisely depending on light sources used in lithography with light exposure, which is a commonly-employed technique at present.

As the light source for lithography employed in resist pattern formation, light exposure using a g-line (436 nm) or an i-line (365 nm) of a mercury lamp is widely adopted for portions where the degree of integration is low. Meanwhile, for portions where the degree of integration is high and finer patterning is required, lithography using a KrF excimer laser (248 nm) or an ArF excimer laser (193 nm) with shorter wavelengths has also been practically used. Moreover, for the most-advanced generation requiring further finer patterning, lithography with extreme ultraviolet ray (EUV, 13.5 nm) is about to be put into practical use.

It is well known that in a monolayer resist method, which is employed as a typical resist patterning process, as the thinning of resist patterns progresses as described above, the ratio of a pattern height to a pattern line width (aspect ratio) is increased, and pattern collapse occurs due to the surface tension of a developer during development. It is known that, in this situation, a multilayer resist method, in which a pattern is formed by laminating films having different dry etching properties, is excellent in forming a pattern with a high aspect ratio on an uneven substrate. There have been developed: a two-layer resist method in which a photoresist layer (resist upper layer film) made of a silicon-containing photosensitive polymer is combined with a resist underlayer film made of an organic polymer containing carbon, hydrogen, and oxygen as main constituent elements, for example, a novolak polymer (Patent Document 1); and a three-layer resist method in which a photoresist layer made of an organic photosensitive polymer used in a monolayer resist method is combined with a resist middle layer film made of a silicon-based polymer or a silicon-based CVD film, and a resist underlayer film made of an organic polymer (Patent Document 2).

In the three-layer resist method, for example, an organic film made of a novolak or the like is formed uniformly as a resist underlayer film on a substrate to be processed; a silicon-containing resist middle layer film is formed thereon as a resist middle layer film; and an ordinary organic photoresist film is formed thereon as a resist upper layer film. In dry etching using a fluorine-based gas plasma, an organic resist upper layer film has favorable etching selectivity to a silicon-containing resist middle layer film, and therefore, a resist pattern is transferred to the silicon-containing resist middle layer film by dry etching using a fluorine-based gas plasma. According to this method, the pattern can be transferred to the silicon-containing resist middle layer film even when using a resist composition that causes difficulties in forming a pattern having a sufficient film thickness for directly processing the substrate to be processed or when using a resist composition that does not have sufficient dry etching resistance for processing the substrate. In addition, by subsequently transferring the pattern by dry etching with an oxygen-based gas plasma, it is possible to obtain a pattern in a novolak film (resist underlayer film) having sufficient dry etching resistance for processing.

Many techniques are already known (e.g. Patent Document 3) regarding organic films like the organic film described above. However, in association with recent progress in miniaturization, the need for excellent filling property in addition to dry etching property is rising. There is a demand for an organic film material that enables uniform film formation even on an underlying substrate to be processed having a complex form or any material, and that has a filling property that allows a required pattern to be filled without gaps.

When a semiconductor substrate or the like is manufactured, the above-described organic film is formed using a coater/developer that can perform treatments such as spin-coating process, EBR process, and baking process. An EBR (Edge Bead Removal) process is a process of removing, after forming a film on a substrate (wafer) by spin-coating, the film on the edge of the substrate with a remover for the purpose of preventing the contamination of a substrate-conveying arm of the coater/developer. A mixed solution of propylene glycol monomethyl ether acetate and propylene glycol monomethyl ether (30 mass%:70 mass%) is a remover used in EBR processes, and is widely used in EBR processes of resist upper layer films, silicon-containing resist middle layer films, and organic films.

Due to the effect of a remover in an EBR process, a state where a peripheral portion of an organic film has a thick film thickness (a hump) occurs in some cases. In the above-described dry etching step at the time of substrate processing, a hump causes defects, and therefore, an organic film in which a hump is suppressed is desired.

### CITATION LIST

### PATENT LITERATURE

Patent Document 1: JP H06-118651 A
Patent Document 2: JP 4355943 B2
Patent Document 3: JP 2004-205685 A

### SUMMARY OF INVENTION

### TECHNICAL PROBLEM

The present invention has been made in view of the above-described circumstances. An object of the present invention is to provide: a composition for forming an organic film which is excellent in film-formability (in-plane uniformity) on a substrate (wafer) and filling property and in which humps in an EBR process are suppressed; a method for forming an organic film, using the composition; and a patterning process.

### SOLUTION TO PROBLEM

To achieve the object, the present invention provides a composition for forming an organic film, comprising: (A) a polymer having a repeating unit represented by the following general formula (1); (B) a resin for forming an organic film; and (C) a solvent, 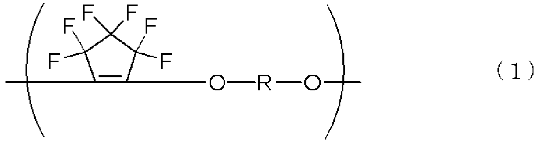 wherein R represents a saturated or unsaturated divalent organic group having 2 to 30 carbon atoms.

Such a composition for forming an organic film makes it possible to form an organic film having excellent in-plane uniformity and filling property and in which the formation of a hump due to the effect of a remover in an EBR process is suppressed.

In the present invention, the polymer (A) preferably has any one or more of the following general formulae (2) to (4), 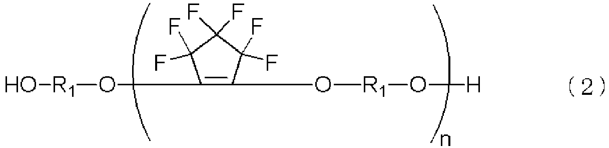 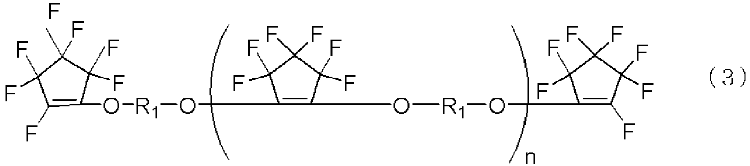 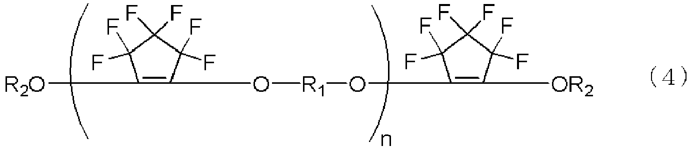 wherein R₁ represents a saturated or unsaturated divalent hydrocarbon group having 4 to 10 carbon atoms and optionally having an ether bond; R₂ represents a monovalent organic group having 1 to 30 carbon atoms; and "n" represents an average repeating unit number of 3 to 2,000.

A composition for forming an organic film containing such a polymer allows better in-plane uniformity in a formed organic film, and is therefore preferable.

In the present invention, the polymer (A) is preferably contained in an amount of 0.01 parts by mass to 5 parts by mass based on 100 parts by mass of the resin (B) for forming an organic film.

A composition for forming an organic film containing the polymer in such an amount allows better in-plane uniformity in a formed organic film, and is therefore preferable.

The present invention also provides a method for forming an organic film to be used in a manufacturing process of a semiconductor device, the method comprising: spin-coating a substrate to be processed with the above-described composition for forming an organic film; and forming an organic film by heating the substrate coated with the composition for forming an organic film at a temperature of 100°C or higher and 600°C or lower for 10 to 600 seconds to cure the composition.

According to the inventive method for forming an organic film, a pattern having a complicated shape on a substrate to be processed is filled by spin-coating, forms an organic film having excellent in-plane uniformity, and is particularly useful when removing an edge portion of the organic film in an EBR process while suppressing a hump.

The present invention also provides a patterning process comprising:
forming an organic film on a body to be processed by using the above-described composition for forming an organic film;
forming a silicon-containing resist middle layer film on the organic film by using a silicon-containing resist middle layer film material;
forming a resist upper layer film on the silicon-containing resist middle layer film by using a resist upper layer film material comprising a photoresist composition;
forming a circuit pattern in the resist upper layer film;
transferring the pattern to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further transferring the pattern to the body to be processed by etching while using the organic film having the transferred pattern as a mask.

The present invention also provides a patterning process comprising:
forming an organic film on a body to be processed by using the above-described composition for forming an organic film;
forming a silicon-containing resist middle layer film on the organic film by using a silicon-containing resist middle layer film material;
forming an organic antireflective film or an adhesive film on the silicon-containing resist middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further transferring the pattern to the body to be processed by etching while using the organic film having the transferred pattern as a mask.

The present invention also provides a patterning process comprising:
forming an organic film on a body to be processed by using the above-described composition for forming an organic film;
forming an inorganic hard mask middle layer film selected from a silicon oxide film, a silicon nitride film, and a silicon oxynitride film on the organic film;
forming a resist upper layer film on the inorganic hard mask middle layer film by using a resist upper layer film material comprising a photoresist composition;
forming a circuit pattern in the resist upper layer film;
transferring the pattern to the inorganic hard mask middle layer film by etching while using the resist upper layer film having the formed circuit pattern as a mask;
transferring the pattern to the organic film by etching while using the inorganic hard mask middle layer film having the transferred pattern as a mask; and
further transferring the pattern to the body to be processed by etching while using the organic film having the transferred pattern as a mask.

The present invention also provides a patterning process comprising:
forming an organic film on a body to be processed by using the above-described composition for forming an organic film;
forming an inorganic hard mask middle layer film selected from a silicon oxide film, a silicon nitride film, and a silicon oxynitride film on the organic film;
forming an organic antireflective film or an adhesive film on the inorganic hard mask middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and the inorganic hard mask middle layer film by etching while using the resist upper layer film having the formed circuit pattern as a mask;
transferring the pattern to the organic film by etching while using the inorganic hard mask middle layer film having the transferred pattern as a mask; and
further transferring the pattern to the body to be processed by etching while using the organic film having the transferred pattern as a mask.

As described, the inventive composition for forming an organic film can be used suitably in various patterning processes such as a three-layer resist process using a silicon-containing resist middle layer film or an inorganic hard mask middle layer film and a four-layer resist process additionally using an organic antireflective film or an adhesive film. According to such patterning processes of the present invention, it is possible to transfer and form a circuit pattern of a resist upper layer film in a body to be processed with high accuracy.

In this event, the inorganic hard mask middle layer film is preferably formed by a CVD method or an ALD method.

In the inventive patterning process, the inorganic hard mask middle layer film can be formed by such methods, for example.

In the present invention, the circuit pattern is preferably formed by a lithography using light having a wavelength of 10 nm or more and 300 nm or less, a direct writing with electron beam, nanoimprinting, or a combination thereof.

In the present invention, the circuit pattern is preferably developed with an alkaline development or an organic solvent.

In the inventive patterning process, such means of forming and developing the circuit pattern can be used suitably.

In the present invention, the body to be processed is preferably a semiconductor device substrate or the semiconductor device substrate coated with any of a metal film, a metal carbide film, a metal oxide film, a metal nitride film, a metal oxycarbide film, and a metal oxynitride film.

In this case, the metal constituting the body to be processed is preferably silicon, titanium, tungsten, hafnium, zirconium, chromium, germanium, copper, silver, gold, aluminum, indium, gallium, arsenic, palladium, iron, tantalum, iridium, molybdenum, or an alloy thereof.

According to the inventive patterning process, such a body to be processed can be processed to form a pattern.

### ADVANTAGEOUS EFFECTS OF INVENTION

As described above, according to the present invention, it is possible to provide a composition for forming an organic film having excellent film-formability (in-plane uniformity) on a substrate (wafer) and filling property, and suppressing humps at the time of an EBR process. Furthermore, such a composition for forming an organic film of the present invention has excellent film-formability, an excellent filling property, and a property of suppressing humps that are generated during an EBR process, and therefore, is extremely useful as: a material for forming an organic film used in multilayer resist processes, such as a two-layer resist process, a three-layer resist process using a silicon-containing resist middle layer film or an inorganic hard mask middle layer film, or a four-layer resist process using a silicon-containing resist middle layer film or inorganic hard mask middle layer film and an organic antireflective film or adhesive film; or a material for forming an organic film for manufacturing a semiconductor device. Moreover, according to the inventive method for forming an organic film, it is possible to form an organic film in which humps are suppressed, and therefore, a semiconductor device and so forth can be manufactured efficiently.

### BRIEF DESCRIPTION OF DRAWINGS

FIG. 1 is an example of a graph on measuring the height of a hump by using a stylus profiler in the case of a composition for forming an organic film where humps have been suppressed.
FIG. 2 is an example of a graph on measuring the height of a hump by using a stylus profiler in the case of a composition for forming an organic film where humps have not been suppressed.
FIG. 3 is an explanatory diagram of an example of the inventive patterning process according to a three-layer resist process.
FIG. 4 is an explanatory diagram of a filling property evaluation method in the Examples.

### DESCRIPTION OF EMBODIMENTS

As described above, there has been required the development of: a composition for forming an organic film having excellent film-formability (in-plane uniformity) on a substrate (wafer) and filling property and in which humps are suppressed during an EBR process; a method for forming an organic film, using the composition; and a patterning process.

Usually, when an organic film is to be formed, a resin for forming an organic film and additives are dissolved in an organic solvent to form a composition, the composition is applied with a coater/developer onto a substrate on which a structure, a circuit, etc. is formed, the composition is spread by the substrate rotating, the composition on the edge is removed in an EBR process, and then the composition is baked to form an organic film.

It is thought that if the flowability of the composition is insufficient, gaps are generated when a hole or trench having a very high aspect ratio is filled, and in addition, a hump is generated in the periphery of the organic film if the resin for forming an organic film or the additives have poor solubility in the remover used in the EBR process.

The present inventors have studied earnestly further and found out that when a polymer having a particular repeating unit is contained in a composition for forming an organic film, the composition has excellent film-formability and high filling property and allows excellent hump suppression during an EBR process. Thus, the present invention has been completed.

That is, the present invention is a composition for forming an organic film, comprising: (A) a polymer having a repeating unit represented by the following general formula (1); (B) a resin for forming an organic film; and (C) a solvent, 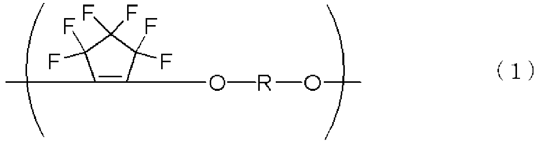 wherein R represents a saturated or unsaturated divalent organic group having 2 to 30 carbon atoms.

Hereinafter, the present invention will be described in detail, but the present invention is not limited thereto.

### [Composition for Forming Organic Film]

The inventive composition for forming an organic film contains: (A) a polymer having a repeating unit represented by the following general formula (1); (B) a resin for forming an organic film; and (C) a solvent.

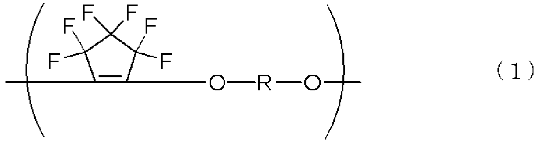

In the general formula (1), R represents a saturated or unsaturated divalent organic group having 2 to 30 carbon atoms.

Note that in the inventive composition for forming an organic film, the polymer (A), the resin (B) for forming an organic film, and the solvent (C) may each be of one kind or a combination of two or more kinds.

Here, an "organic group" in the present invention means a "group containing at least one carbon atom", and the group may further contain a hydrogen atom and may also contain a nitrogen atom, an oxygen atom, a sulfur atom, a silicon atom, a halogen atom, etc.

### [(A) Polymer]

The polymer (A) contained in the inventive composition for forming an organic film has a repeating unit represented by the general formula (1).

In the general formula (1), R represents a saturated or unsaturated divalent organic group having 2 to 30 carbon atoms. R may be of a single kind or multiple kinds of R may be present in mixture. Examples of the R include the following.

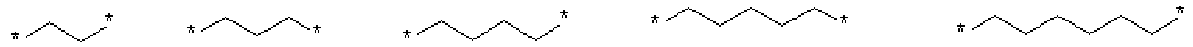

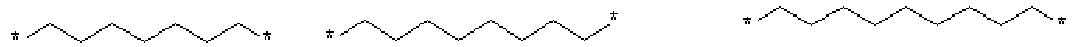

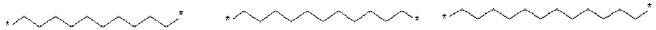

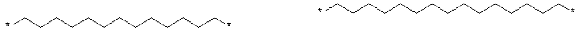

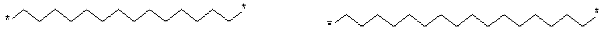

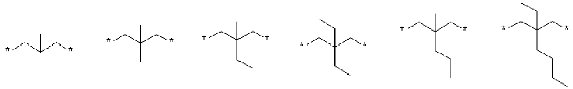

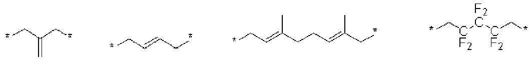

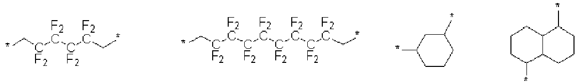

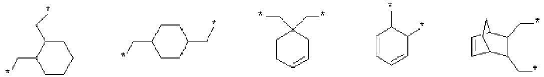

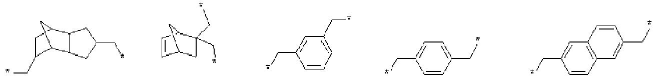

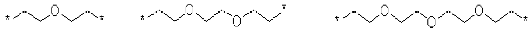

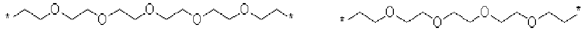

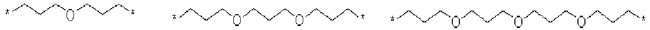

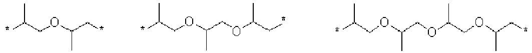

In the formulae, "*" represents an attachment point to an oxygen atom.

Furthermore, the polymer (A) preferably has any one or more of the following general formulae (2) to (4).

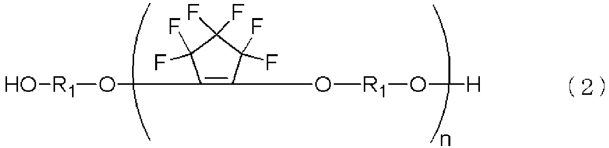

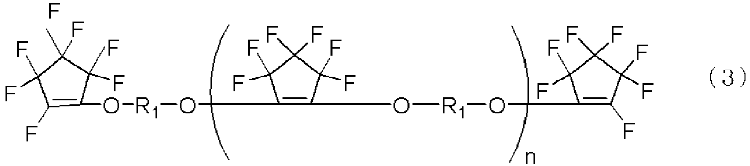

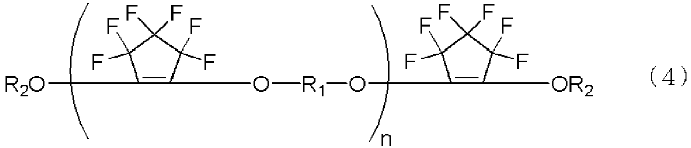

In the formulae, R₁ represents a saturated or unsaturated divalent hydrocarbon group having 4 to 10 carbon atoms and optionally having an ether bond; R₂ represents a monovalent organic group having 1 to 30 carbon atoms; and "n" represents an average repeating unit number of 3 to 2,000.

The R₁ in the general formulae (2) to (4) represents a saturated or unsaturated divalent hydrocarbon group having 4 to 10 carbon atoms and optionally having an ether bond. R₁ may be of one kind or multiple kinds thereof may coexist, and examples include the following. In particular, those having a glyme chain are preferable from the viewpoint of surface tension control.

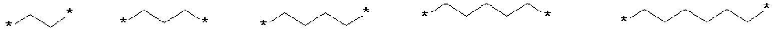

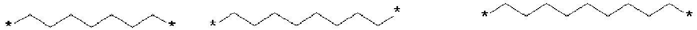

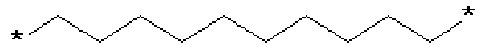

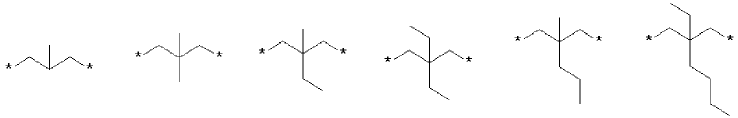

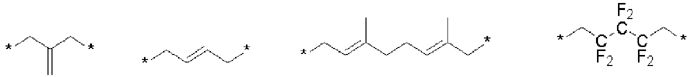

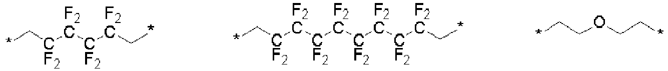

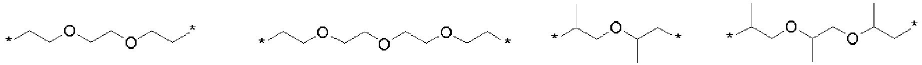

In the formulae, "*" represents an attachment point to an oxygen atom.

In the general formula (4), R₂ represents a monovalent organic group having 1 to 30 carbon atoms. Specific examples include a methyl group, an ethyl group, a vinyl group, a 2,2,2-trifluoroethyl group, a propyl group, an isopropyl group, an allyl group, a 1-propenyl group, an isopropenyl group, a butyl group, an s-butyl group, a t-butyl group, an isobutyl group, a pentyl group, a cyclopentyl group, a hexyl group, a cyclohexyl group, a cyclohexenyl group, a decyl group, a dodecyl group, an icosanyl group, a norbornyl group, an adamantyl group, a phenyl group, a toluyl group, a xylyl group, a naphthyl group, a phenanthrenyl group, an anthracenyl group, a benzyl group, a fluorenyl group, a naphthylmethyl group, a norbornenyl group, triacontyl group, a 2-furanyl group, a 2-tetrahydrofuranyl group, an anisyl group, an acryloyl group, a methacryloyl group, an acetyl group, etc. When the R₂ has an aromatic ring, the aromatic ring may have a substituent thereon, and examples of the substituent include: halogen groups, such as fluorine, chlorine, bromine, and iodine; alkyloxy groups, such as a methoxy group and an ethoxy group; alkenyloxy groups, such as an allyloxy group; alkynyloxy groups, such as a propargyloxy group; etc. A hydrogen atom on a methylene contained in these alkylene groups may be substituted with a fluorine atom.

When the polymer contains such a structure, the surface tension of the composition for forming an organic film can be controlled, and the polymer has a property of excellent compatibility to a solvent. Therefore, it is possible to form, by spin-coating, an organic film having better in-plane uniformity. It is also possible to make adjustments to achieve a desired property by adjusting appropriately multiple structures and terminal structures of the R₁.

"n" represents an average repeating unit number of 3 to 2,000, preferably 3 to 500, more preferably 5 to 300.

The polymer (A) may have only one kind of repeating unit as the repeating unit represented by the general formula (1), or may have a combination of two or more kinds of repeating units.

Specific examples of repeating units represented by the general formula (1) include the following, but are not limited thereto.

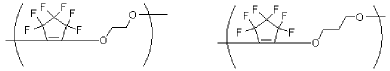

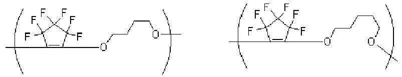

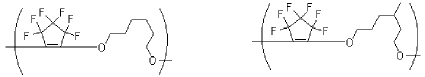

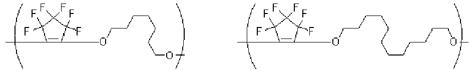

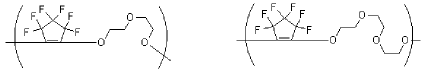

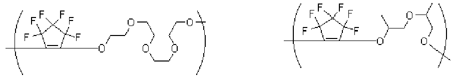

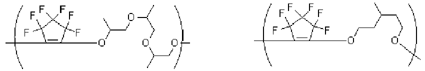

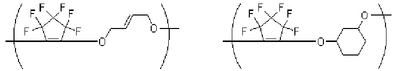

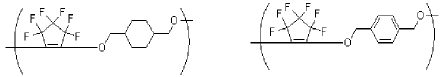

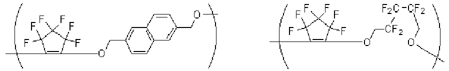

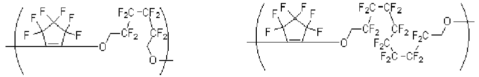

Specific examples of the polymer (A) represented by the general formula (2) include the following, but are not limited thereto.

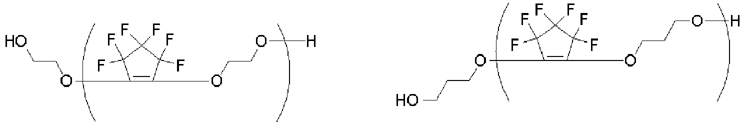

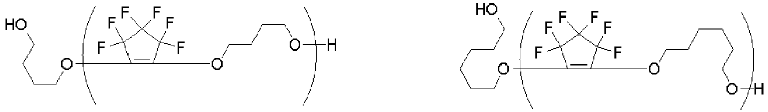

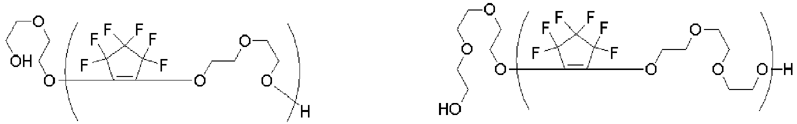

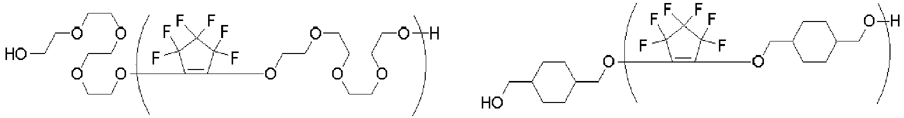

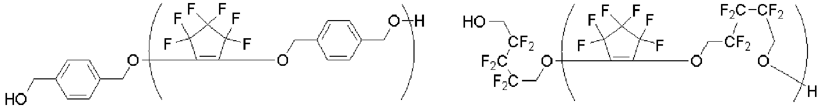

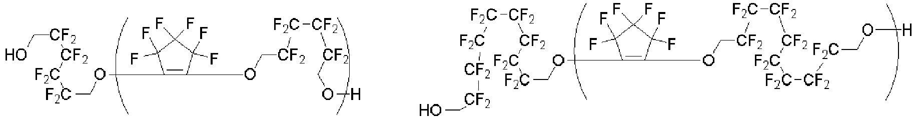

Specific examples of the polymer (A) represented by the general formula (3) include the following, but are not limited thereto.

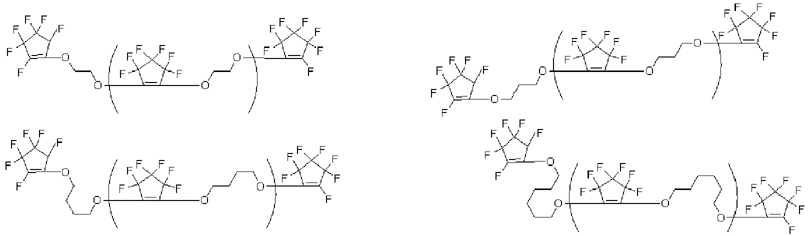

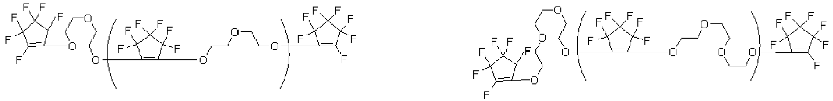

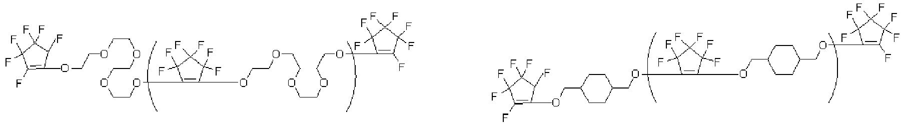

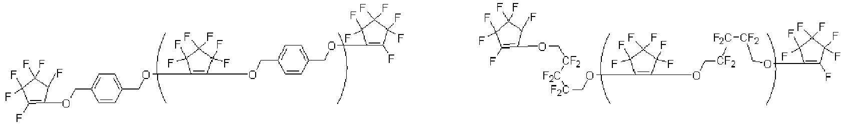

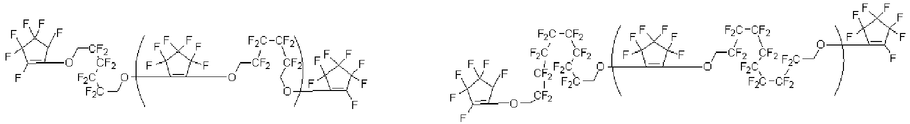

Specific examples of the polymer (A) represented by the general formula (4) include the following, but are not limited thereto.

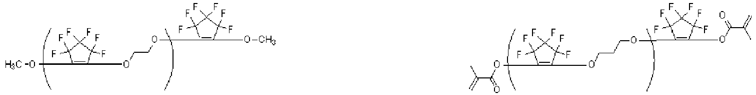

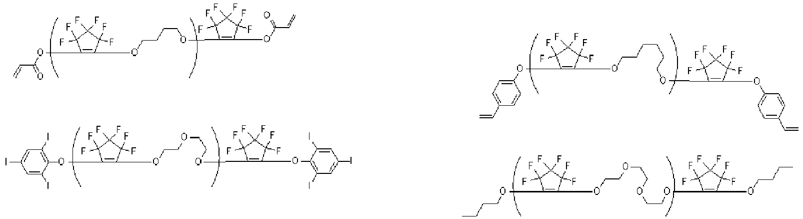

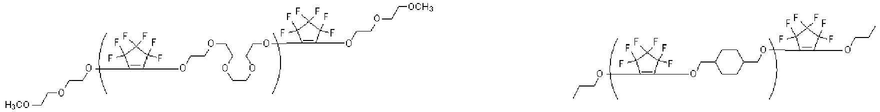

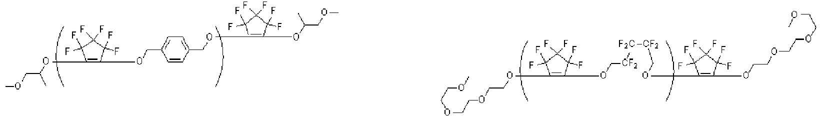

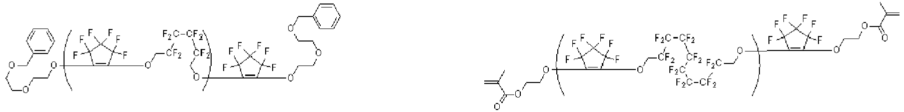

The properties of the polymer (A) can be adjusted as necessary by the choice of the structures of the R, R₁, and R₂. In particular, it is possible to control the polarity of the polymer and adjust film-formability and solvent solubility.

The polymer (A) preferably has a weight-average molecular weight of 300 to 200,000, more preferably 300 to 50,000, and further preferably 500 to 40,000. The average number of repeating units is preferably 3 to 2,000, further preferably 3 to 500. When the weight-average molecular weight is 300 or more, it is possible to suppress the degradation of a blending effect due to volatilization and so forth, and a sufficient blending effect can be achieved. Meanwhile, when the weight-average molecular weight is 200,000 or less, there is no risk of flowability being degraded and so forth, and excellent filling and planarizing properties can be achieved. The weight-average molecular weight of the polymer (A) can be determined, for example, as a weight-average molecular weight (Mw) measured in terms of polystyrene by gel permeation chromatography (GPC) using tetrahydrofuran as an eluent (solvent).

Examples of a method for manufacturing a polymer having a repeating unit represented by the general formula (1) include a method of obtaining a polymer by an etherification reaction or the like between the octafluorocyclopentene shown below and a diol having R as a partial structure in the presence of a base catalyst.

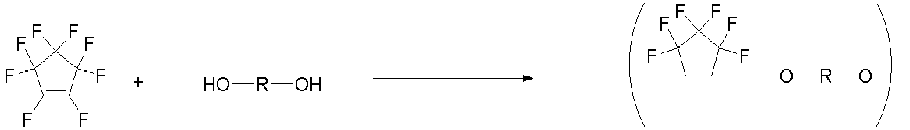

In the formulae, R is as defined above.

Examples of the base catalyst of the etherification reaction shown above include: inorganic basic compounds, such as sodium hydrogen carbonate, sodium carbonate, potassium carbonate, calcium carbonate, cesium carbonate, sodium hydroxide, potassium hydroxide, sodium hydride, and potassium phosphate; and organic amine compounds, such as triethylamine, pyridine, and N-methylmorpholine. One of these base catalysts may be used or a combination of two or more kinds thereof may be used. The catalyst can be used in an amount of 0.1 to 20 mol, preferably 0.2 to 10 mol, relative to the hydroxy groups, which are substituents of the raw material.

A solvent used in this event is not particularly limited as long as the solvent is inactive to the reaction. Examples thereof include: ether solvents, such as diethyl ether, tetrahydrofuran, and dioxane; aromatic solvents, such as benzene, toluene, and xylene; acetonitrile; dimethyl sulfoxide; N,N-dimethylformamide; N-methylpyrrolidone; and water. One of these solvents may be used, or a mixture thereof may be used. These solvents can be used within a range of 0 to 2,000 parts by mass relative to 100 parts by mass of the reaction raw material. The reaction temperature is preferably from -50°C to approximately the boiling point of the solvent, further preferably room temperature to 150°C. The reaction time is appropriately selected from 0.1 to 100 hours.

If necessary, the obtained polymer can be purified by a conventional method, such as liquid-liquid separation, crystallization, concentration under reduced pressure, dialysis, and ultrafiltration, depending on the properties of the polymer. Furthermore, if necessary, the metal content can be reduced by passing the polymer through a commercially available demetallization filter.

Examples of methods for the reaction include: a method in which octafluorocyclopentene and a diol are charged in a solvent at once; a method in which each of or a mixture of octafluorocyclopentene and a diol is dispersed or dissolved, and the resultant is charged by adding dropwise; a method in which one of octafluorocyclopentene and a diol is dispersed or dissolved in a solvent, and then the other, dispersed or dissolved in a solvent, is charged by adding dropwise; etc. In addition, in a case where multiple kinds of diol are charged, the diols may be mixed together beforehand and then subjected to a reaction, or the diols may be subjected to a reaction individually in succession. In a case where a catalyst is used, examples of methods include: a method in which the catalyst is charged at once with the octafluorocyclopentene and the diol; a method in which the catalyst is dispersed or dissolved beforehand, and then added dropwise; etc. After completion of the reaction, the reaction product may be diluted in an organic solvent in order to remove unreacted raw materials, the catalyst, etc. present in the system, and then a crystal may be precipitated by liquid-liquid separation washing or with a poor solvent and obtained as a powder. Alternatively, after the dilution in the organic solvent, solvent substitution to a desired organic solvent may be performed, and the polymer may be collected as a solution. Furthermore, the polymer may also be dissolved in a desired organic solvent and collected as a solution after being collected as a powder by crystallization or the like.

The organic solvent used when the liquid-liquid separation washing is performed is not particularly limited, as long as it is capable of dissolving the target product and being separated into two layers when mixed with water. Examples of the organic solvent include hydrocarbons, such as hexane, heptane, benzene, toluene, and xylene; esters, such as ethyl acetate, n-butyl acetate, and propylene glycol methyl ether acetate; ketones, such as methyl ethyl ketone, methyl amyl ketone, cyclohexanone, and methyl isobutyl ketone; ethers, such as diethyl ether, diisopropyl ether, methyl-tert-butyl ether, and ethylcyclopentylmethyl ether; chlorinated solvents, such as methylene chloride, chloroform, dichloroethane, and trichloroethylene; mixtures thereof; and the like. As the water used for washing in this event, generally, what is called deionized water or ultrapure water may be used. The washing may be performed once or more, preferably approximately once to five times, because washing ten times or more does not always produce the full washing effects thereof.

In the liquid-liquid separation washing, the washing may be performed with a basic aqueous solution to remove acidic components in the system. Specific examples of the base include hydroxides of alkaline metals, carbonates of alkaline metals, hydroxides of alkali earth metals, carbonates of alkali earth metals, ammonia, organic ammonium, etc.

Further, in the liquid-liquid separation washing, the washing may be performed with an acidic aqueous solution to remove metal impurities or basic components in the system. Specific examples of the acid include inorganic acids, such as hydrochloric acid, hydrobromic acid, sulfuric acid, nitric acid, phosphoric acid, and heteropoly acid; organic acids, such as oxalic acid, fumaric acid, maleic acid, trifluoroacetic acid, methanesulfonic acid, benzenesulfonic acid, p-toluenesulfonic acid, and trifluoromethanesulfonic acid; etc.

The liquid-liquid separation washing may be performed with any one of the basic aqueous solution and the acidic aqueous solution, or can be performed with a combination of the two. The liquid-liquid separation washing is preferably performed with the basic aqueous solution and the acidic aqueous solution in this order from the viewpoint of removing the metal impurities.

After the liquid-liquid separation washing with the basic aqueous solution and/or acidic aqueous solution, washing with neutral water may be successively performed. This washing may be performed once or more, preferably approximately once to five times. As the neutral water, deionized water, ultrapure water, or the like mentioned above may be used. The washing may be performed once or more, but if the washing is not performed sufficiently, the basic components and the acidic components may not be removed in some cases. The washing is performed preferably approximately once to five times because washing ten times or more does not always produce the full washing effects.

Further, the reaction product after the liquid-liquid separation operation can also be collected as a powder by concentrating and drying the solvent or crystallizing the reaction product under reduced pressure or normal pressure. Alternatively, the reaction product can be retained in a solution state with an appropriate concentration to improve the workability in preparing a composition for forming an organic film. The concentration at this point is preferably 0.1 to 50 mass%, more preferably 0.5 to 30 mass%. With such a concentration, the viscosity is hardly increased, preventing degradation of the workability; in addition, since the amount of the solvent is not excessive, the solution can be prepared economically.

The solvent in this event is not particularly limited, as long as it is capable of dissolving the reaction product. Specific examples of the solvent include ketones, such as cyclohexanone and methyl-2-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate. One of these or a mixture of two or more thereof can be used.

The polymers represented by the general formulae (2) and (3) can be manufactured easily by adjusting the proportion of the octafluorocyclopentene and the diol having R₁ as a partial structure to charge. Specifically, when the number of moles of the octafluorocyclopentene to be charged is "a" and the number of moles of the diol having R₁ as a partial structure to be charged is "b", in the case of (2), the charging ratio of the diol having R₁ as a partial structure to the octafluorocyclopentene can be made high, that is, the charging ratio can be a < b. In this case, an unreacted alcohol can be retained on an end by allowing the diol component to be excessive. Similarly, in the case of (3), the charging ratio of the octafluorocyclopentene to the diol having R₁ as a partial structure can be made high, that is, the charging ratio can be a > b. In this case, the polymer is end-capped with octafluorocyclopentene.

### [Manufacturing Method for (2): Case Where Charging Ratio is a < b]

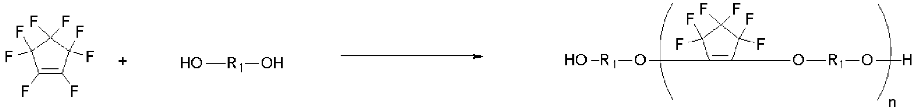

In the formulae, R₁ and "n" are as defined above.

### [Manufacturing Method for (3): Case Where Charging Ratio is a > b]

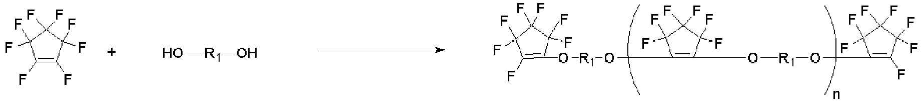

In the formulae, R₁ and "n" are as defined above.

Furthermore, in the case of the general formula (4), there is a method of further etherifying an end of the polymer represented by the general formula (3) with an alcohol or carboxylic acid having R₂ as a substituent. Alternatively, there is a method of etherifying a diol having R₁ as a partial structure, an alcohol or carboxylic acid having R₂ as a substituent, and octafluorocyclopentene at once. When the ingredients are charged at once, it is necessary to control the charging ratio strictly, and from an industrial aspect, the preferable method is the method of manufacturing the polymer represented by (3), and then end-capping the polymer with an alcohol or carboxylic acid having R₂ as a substituent.

### [End-Capping Polymer of (3)]

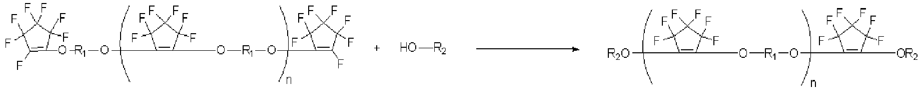

In the formulae, R₁, R₂, and "n" are as defined above.

### [Charging at Once]

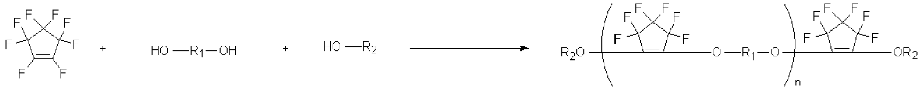

In the formulae, R₁, R₂, and "n" are as defined above.

The manufacturing methods for (2) and (3) can be performed according to the manufacturing method for (1) described above just by adjusting the charging ratio of the octafluorocyclopentene and the diol having R₁ as a partial structure in accordance with the desired structure. The reaction method and the method for collecting the polymer can be performed according to the methods described in the method for manufacturing the polymer of the general formula (1) described above.

Regarding the manufacturing method for (4), when the ingredients are to be charged at once, the method can be performed according to the manufacturing method, reaction method, and polymer-collecting method for (1), except that the alcohol or carboxylic acid having R₂ as a substituent is additionally used simultaneously with the diol having R₁ as a partial structure. When the end-capping of the polymer of (3) is to be performed, the following methods are possible: a method in which, after once collecting the polymer of (3), the alcohol or carboxylic acid having R₂ as a substituent is allowed to react in the same manner as the method for manufacturing the polymer of (1); and a method in which the reaction with the diol having R₁ as a partial structure at the time of the reaction when manufacturing the polymer of (3) is completed, and then the alcohol or carboxylic acid, having R₂ as a substituent, to be used for end-capping is charged, thus, performing the reaction in one pot. Either reaction method can be performed according to the manufacturing method, reaction method, and method for collecting the polymer of (1), except that the substances are different.

### [(B) Resin for Forming Organic Film]

The resin (B) for forming an organic film contained in the inventive composition for forming an organic film is not particularly limited as long as the resin is a resin or compound that has sufficient film-formability in spin-coating and curability. From the viewpoints of etching resistance, optical characteristics, heat resistance, etc., a resin or compound including an aromatic skeleton is preferable.

Examples of the aromatic skeleton include benzene, naphthalene, anthracene, pyrene, indene, fluorene, furan, pyrrole, thiophene, phosphole, pyrazole, oxazole, isoxazole, thiazole, pyridine, pyrazine, pyrimidine, pyridazine, triazine, carbazole, etc. In particular, benzene, naphthalene, fluorene, and carbazole are particularly preferable.

Examples of the resin (B) for forming an organic film used in the present invention include resins containing the following structures, disclosed in JP 2012-001687 A and JP 2012-077295 A.

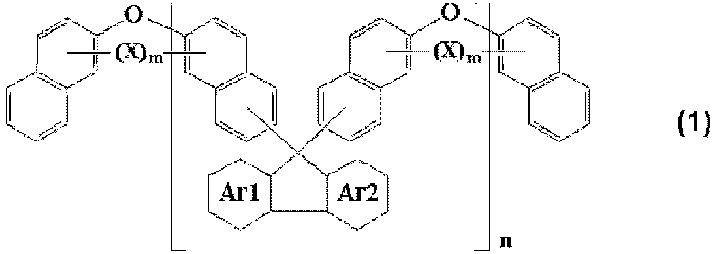

In the formula (1), the cyclic structures Ar1 and Ar2 each represent a benzene ring or a naphthalene ring. X represents a single bond or an alkylene group having 1 to 20 carbon atoms. "m" represents 0 or 1. "n" represents any natural number that provides a molecular weight of 100,000 or less. Note that the symbols in the formula apply only in this formula.

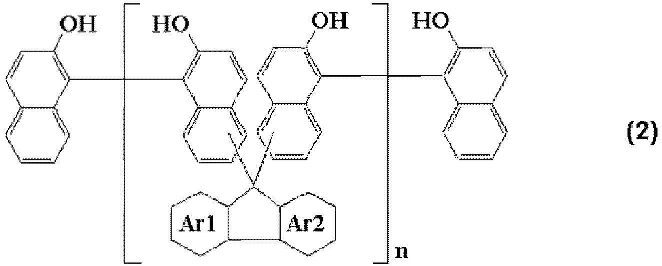

In the formula (2), the cyclic structures Ar1 and Ar2 each represent a benzene ring or a naphthalene ring. "n" represents any natural number that provides a weight-average molecular weight of 100,000 or less as measured by gel permeation chromatography in terms of polystyrene. Note that the symbols in the formula apply only in this formula.

Further examples of the resin (B) for forming an organic film used in the present invention include resins containing the following structures, disclosed in JP 2004-264710 A, JP 2005-043471 A, JP 2005-250434 A, JP 2007-293294 A, and JP 2008-065303 A.

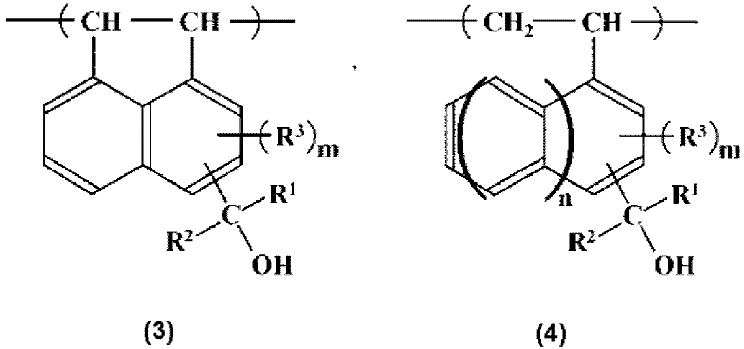

In the formula (3) and the formula (4), R¹ and R² each represent a hydrogen atom, an alkyl group having 1 to 3 carbon atoms, or an aryl group; R³ represents an alkyl group having 1 to 3 carbon atoms, a vinyl group, an allyl group, or an aryl group that is optionally substituted; "n" represents 0 or 1, and "m" represents 0, 1, or 2. Note that the symbols in the formula apply only in this formula.

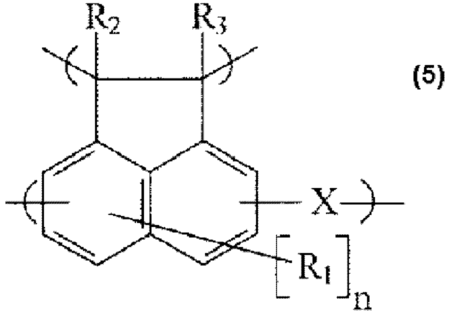

In the formula (5), R₁ represents a monovalent atom other than a hydrogen atom or a monovalent group; and "n" represents an integer of 0 to 4. Here, when "n" is 2 to 4, the multiple R₁'s may be identical to or different from each other. R₂ and R₃ each independently represent a monovalent atom or group. X represents a divalent group. Note that the symbols in the formula apply only in this formula.

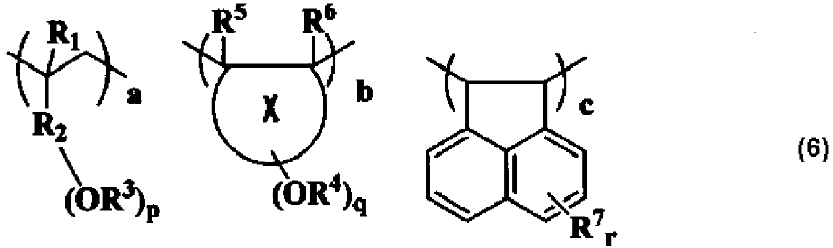

In the formula (6), R₁ represents a hydrogen atom or a methyl group. R₂ represents a single bond, a linear, branched, or cyclic alkylene group having 1 to 20 carbon atoms, or an arylene group having 6 to 10 carbon atoms, and may have any of ether, ester, lactone, and amide. R³ and R⁴ each represent a hydrogen atom or a glycidyl group. X represents any polymer of a hydrocarbon including an indene skeleton, a cycloolefin having 3 to 10 carbon atoms, and maleimide, and may have any of ether, ester, lactone, and carboxylic anhydride. R⁵ and R⁶ each represent a hydrogen atom, a fluorine atom, a methyl group, or a trifluoromethyl group. R⁷ represents a hydrogen atom, a linear, branched, or cyclic alkyl group having 1 to 6 carbon atoms, a hydroxy group, or an alkoxycarbonyl group. "p" and "q" each represent an integer of 1 to 4. "r" represents an integer of 0 to 4. "a", "b", and "c" each satisfy 0.5 ≤ a+b+c ≤ 1, 0 ≤ a ≤ 0.8, 0 ≤ b ≤ 0.8, 0.1 ≤ a+b ≤ 0.8, and 0.1 ≤ c ≤ 0.8. Note that the symbols in the formula apply only in this formula.

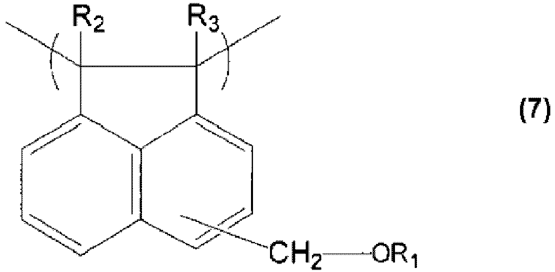

In the formula (7), R₁ represents a hydrogen atom or a monovalent organic group; and R₂ and R₃ each independently represent a monovalent atom or a monovalent organic group. Note that the symbols in the formula apply only in this formula.

Specific examples of the resin (B) for forming an organic film used in the present invention include resins containing the following structures, disclosed in JP 2004-205685 A, JP 2007-171895 A, and JP 2009-014816 A.

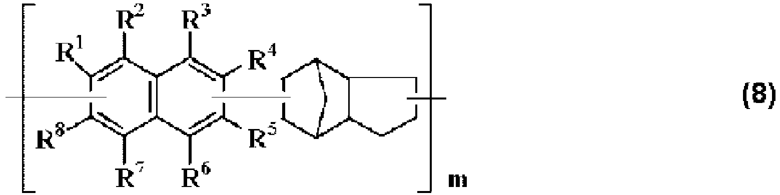

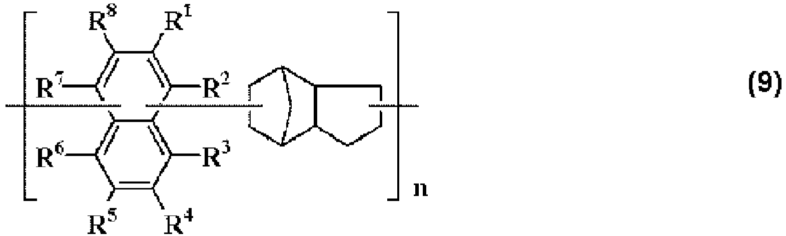

In the formula (8) and the formula (9), R¹ to R⁸ each independently represent a hydrogen atom, a hydroxy group, an alkyl group having 1 to 6 carbon atoms and optionally being substituted, an alkoxy group having 1 to 6 carbon atoms and optionally being substituted, an alkoxycarboxy group having 2 to 6 carbon atoms and optionally being substituted, an aryl group having 6 to 10 carbon atoms and optionally being substituted, a hydroxyalkyl group having 1 to 6 carbon atoms, an isocyanate group, or a glycidyl group. "m" and "n" each represent a positive integer. Note that the symbols in the formula apply only in this formula.

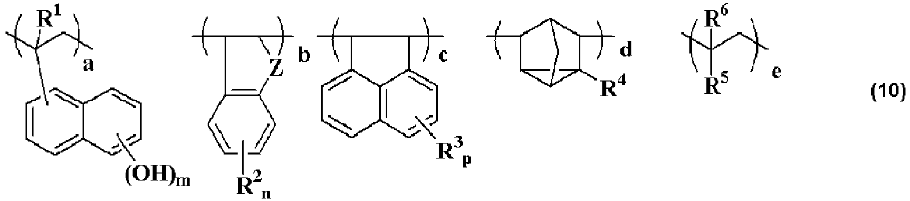

In the formula (10), R¹ and R⁶ each represent a hydrogen atom or a methyl group. R², R³, and R⁴ each represent a hydrogen atom, an alkyl group having 1 to 4 carbon atoms, an alkoxy group, a hydroxy group, an acetoxy group, an alkoxycarbonyl group, or an aryl group having 6 to 10 carbon atoms; R⁵ represents a condensed polycyclic hydrocarbon group having 13 to 30 carbon atoms, -O-R⁷, -C(=O)-O-R⁷, -O-C(=O)-R⁷, or -C(=O)-NR⁸-R⁷; "m" represents an integer of 1 or 2; "n" represents an integer of 0 to 4; and "p" represents an integer of 0 to 6. R⁷ represents an organic group having 7 to 30 carbon atoms; R⁸ represents a hydrogen atom or a hydrocarbon group having 1 to 6 carbon atoms. Z represents a methylene group, -O-, -S-, or -NH-. "a", "b", "c", "d", and "e" each satisfy 0 < a < 1.0, 0 ≤ b ≤ 0.8, 0 ≤ c ≤ 0.8, 0 ≤ d ≤ 0.8, 0 ≤ e ≤ 0.8, and 0 < b+c+d+e < 1.0. Note that the symbols in the formula apply only in this formula.

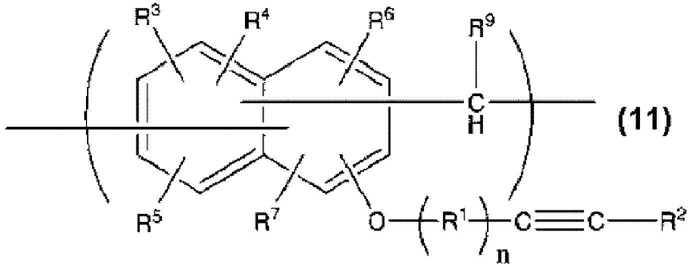

In the formula (11), "n" represents 0 or 1. R¹ represents a methylene group that is optionally substituted, an alkylene group having 2 to 20 carbon atoms and optionally being substituted, or an arylene group having 6 to 20 carbon atoms and optionally being substituted. R² represents a hydrogen atom, an alkyl group having 1 to 20 carbon atoms and optionally being substituted, or an aryl group having 6 to 20 carbon atoms and optionally being substituted. R³ to R⁷ each represent a hydroxy group, an alkyl group having 1 to 6 carbon atoms and optionally being substituted, an alkoxy group having 1 to 6 carbon atoms and optionally being substituted, an alkoxycarbonyl group having 2 to 10 carbon atoms and optionally being substituted, an aryl group having 6 to 14 carbon atoms and optionally being substituted, or a glycidyl ether group having 2 to 6 carbon atoms and optionally being substituted. R⁹ represents a hydrogen atom, a linear, branched, or cyclic alkyl group having 1 to 10 carbon atoms, a linear, branched, or cyclic alkyl ether group having 1 to 10 carbon atoms, or an aryl group having 6 to 10 carbon atoms. Note that the symbols in the formula apply only in this formula.

Examples of the formula (11) include the following resins.

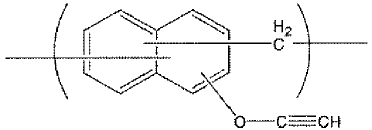

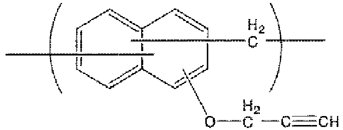

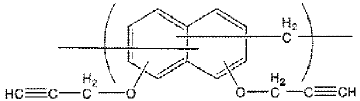

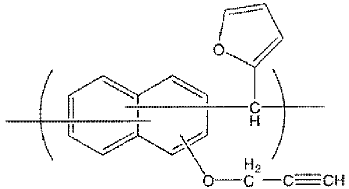

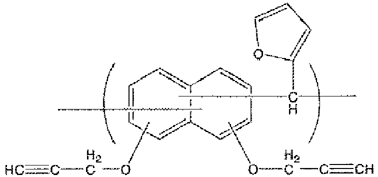

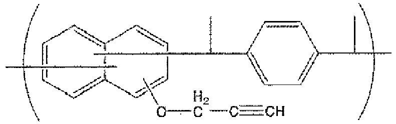

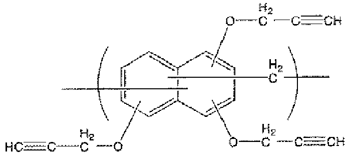

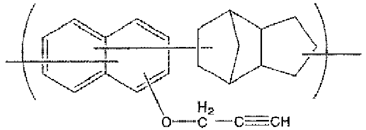

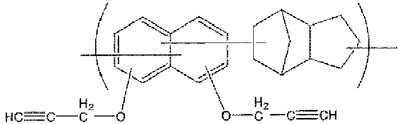

Examples of the resin (B) for forming an organic film used in the present invention include resins containing the following structures, disclosed in JP 2007-199653 A, JP 2008-274250 A, and JP 2010-122656 A.

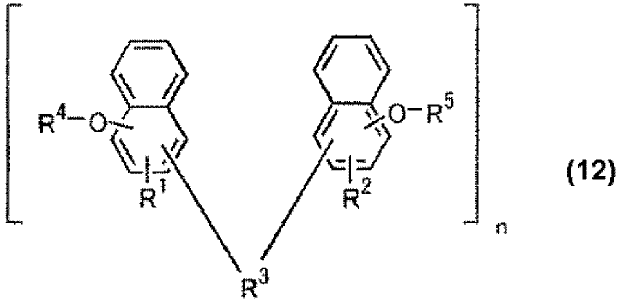

In the formula (12), R¹ and R² are identical to or different from each other and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or a linear, branched, or cyclic alkylene group having 1 to 30 carbon atoms, and optionally has a bridged cyclic hydrocarbon group, a double bond, a heteroatom, or an aromatic group having 6 to 30 carbon atoms; R⁴ and R⁵ each independently represent a hydrogen atom or a glycidyl group; and "n" represents an integer of 1 to 4. Note that the symbols in the formula apply only in this formula.

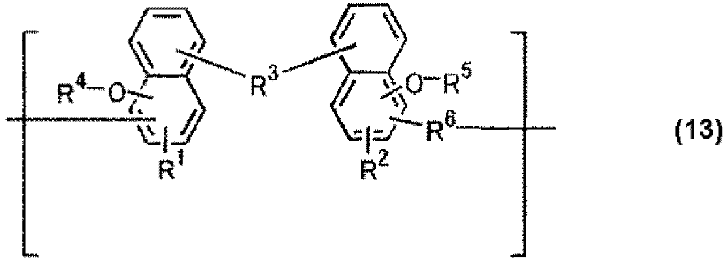

In the formula (13), R¹ and R² are identical to or different from each other and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or a linear, branched, or cyclic alkylene group having 1 to 30 carbon atoms, and optionally has a bridged cyclic hydrocarbon group, a double bond, a heteroatom, or an aromatic group having 6 to 30 carbon atoms; R⁴ and R⁵ each independently represent a hydrogen atom or a glycidyl group; and R⁶ represents a single bond or a linear or branched alkylene group having 1 to 10 carbon atoms. Note that the symbols in the formula apply only in this formula.

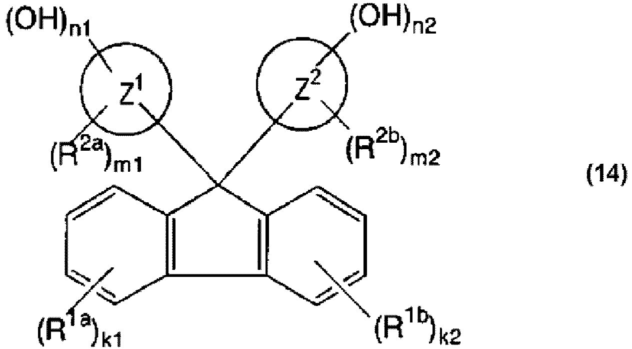

In the formula (14), the ring Z¹ and the ring Z² each represent a condensed polycyclic aromatic hydrocarbon ring; and R^{1a}, R^{1b}, R^{2a}, and R^{2b} are identical to or different from each other and each represent a substituent. "k1" and "k2" are identical to or different from each other and each represent 0 or an integer of 1 to 4; "m1" and "m2" each represent 0 or an integer of 1 or more; and "n1" and "n2" each represent 0 or an integer of 1 or more. Here, n1+n2 ≥ 1. Note that the symbols in the formula apply only in this formula.

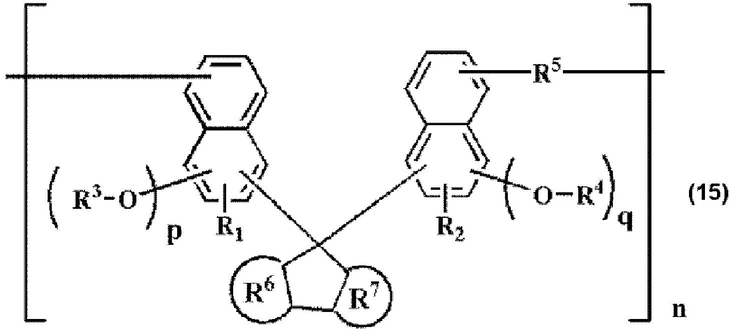

In the formula (15), R₁ and R₂ are identical to or different from each other, and each represent a hydrogen atom, a linear, branched, or cyclic alkyl group having 1 to 10 carbon atoms, an aryl group having 6 to 10 carbon atoms, or an alkenyl group having 2 to 10 carbon atoms. R³ and R⁴ each represent a hydrogen atom or a glycidyl group; R⁵ represents a single bond or a linear or branched alkylene group having 1 to 10 carbon atoms; and R⁶ and R⁷ each represent a benzene ring or a naphthalene ring. "p" and "q" each represent 1 or 2. "n" satisfies 0 < n ≤ 1. Note that the symbols in the formula apply only in this formula.

Examples of the formula (15) include the following resins.

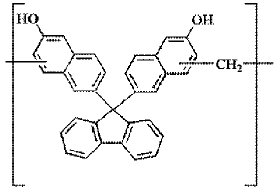

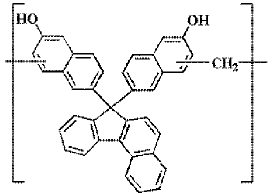

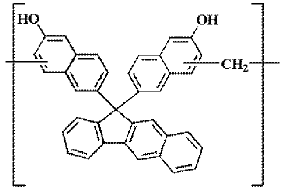

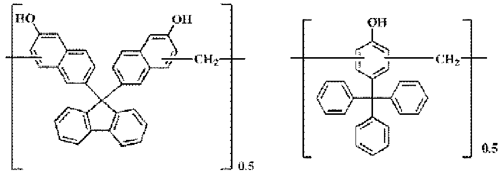

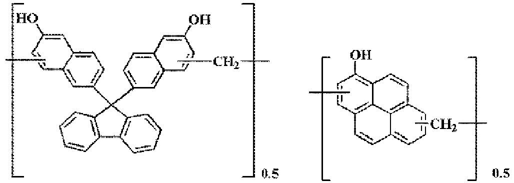

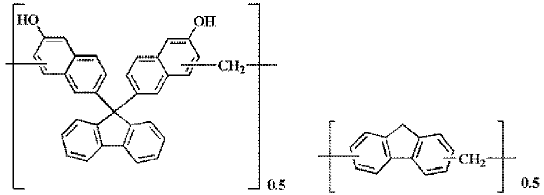

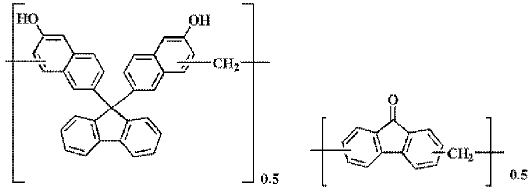

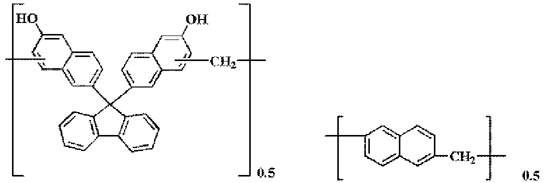

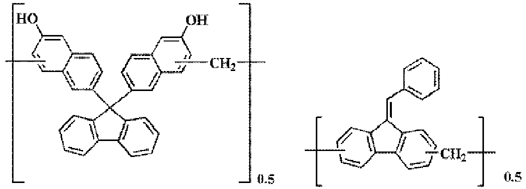

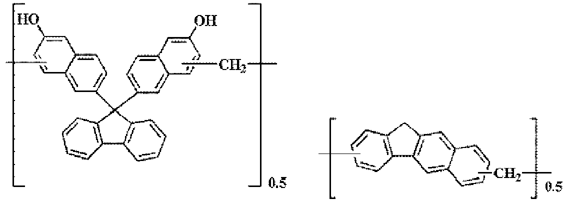

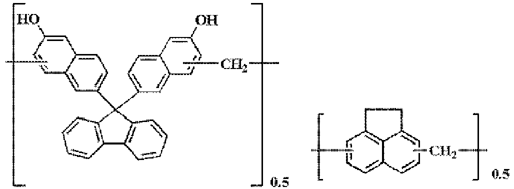

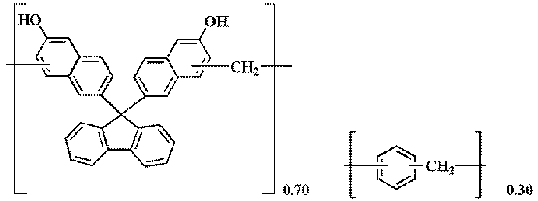

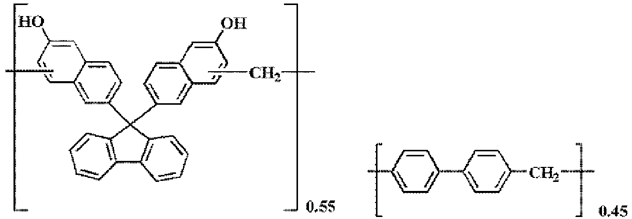

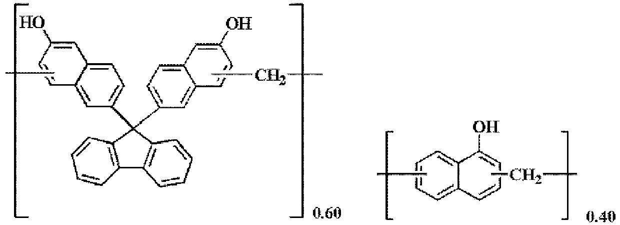

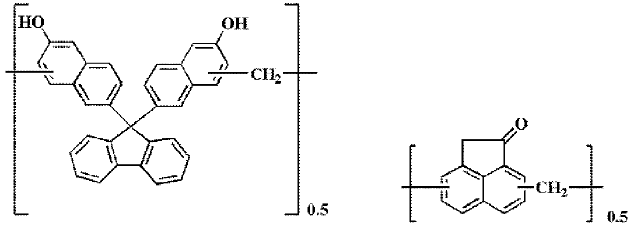

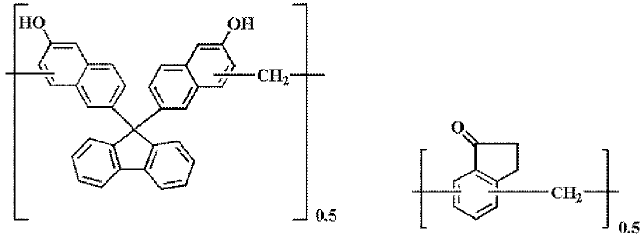

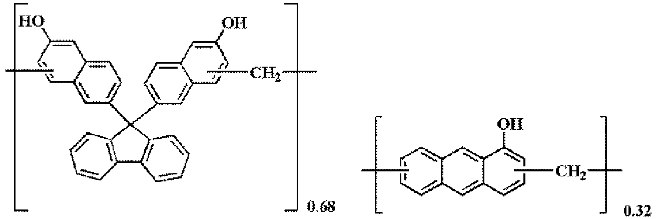

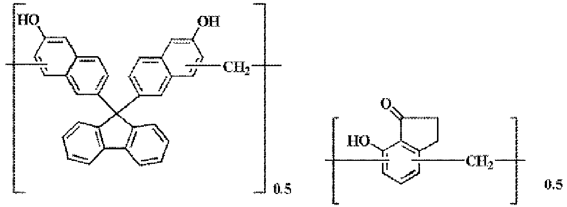

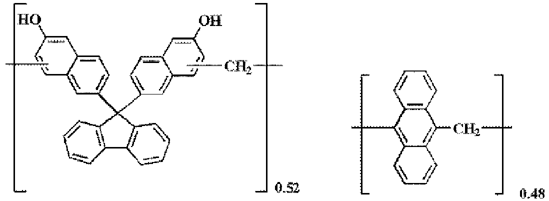

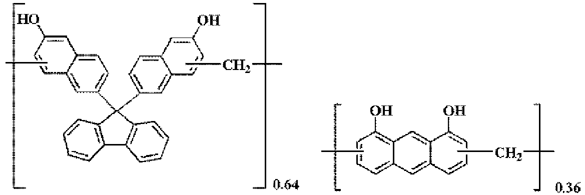

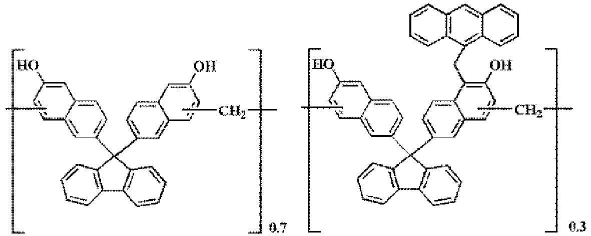

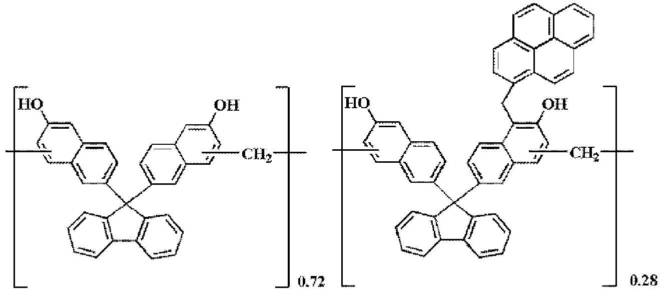

Examples of the resin (B) for forming an organic film used in the present invention include resins containing the following structure, disclosed in JP 2012-214720 A.

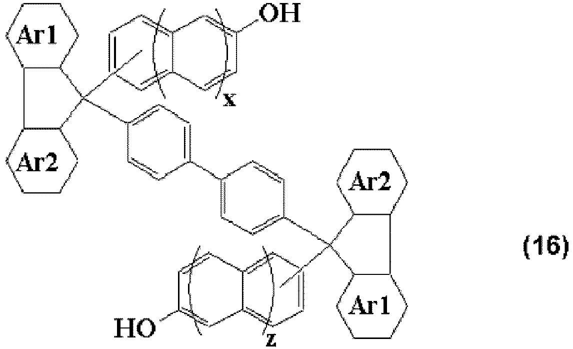

In the formula (16), the cyclic structures Ar1 and Ar2 each represent a benzene ring or a naphthalene ring. "x" and "z" each independently represent 0 or 1. Note that the symbols in the formula apply only in this formula.

Examples of the resin (B) for forming an organic film used in the present invention include resins disclosed in JP 2014-029435 A.

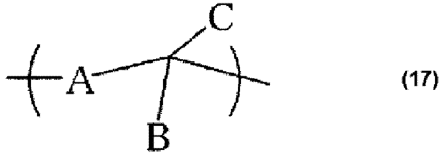

In the formula (17), A represents a structure having carbazole, B represents a structure having an aromatic ring, and C represents a hydrogen atom, an alkyl group, or a structure having an aromatic ring, B and C optionally constituting a ring with each other. 1 to 4 carboxyl groups, a salt thereof, or a carboxylic acid ester group is contained in the structure of A, B, and C combined. Note that the symbols in the formula apply only in this formula.

Examples of the resin (B) for forming an organic film used in the present invention also include polymers disclosed in WO 2012/077640 A1, the polymers containing a unit structure represented by the following formula (18) and a unit structure represented by the following formula (19), where the ratio of the unit structure represented by the formula (18) to the unit structure represented by the formula (19) is 3 to 97:97 to 3 by molar ratio.

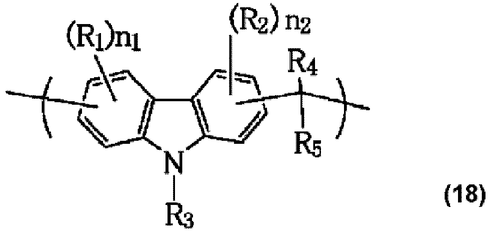

In the formula (18), R₁ and R₂ each independently represent a hydrogen atom, a halogen atom, a nitro group, an amino group, a hydroxy group, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R³ represents a hydrogen atom, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₄ represents a hydrogen atom, or an aryl group or heterocyclic group having 6 to 40 carbon atoms and optionally being substituted with a halogen atom, a nitro group, an amino group, or a hydroxy group; R₅ represents a hydrogen atom, or an alkyl group having 1 to 10 carbon atoms, aryl group having 6 to 40 carbon atoms, or heterocyclic group optionally substituted with a halogen atom, a nitro group, an amino group or a hydroxy group; and R₄ and R₅ may form a ring with each other. "n1" and "n2" each represent an integer of 1 to 3. Note that the symbols in the formula apply only in this formula.

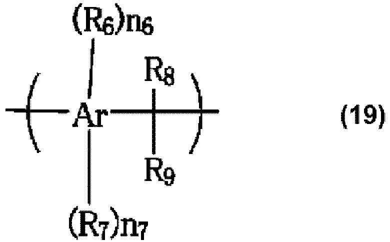

In the formula (19), Ar represents an aromatic ring group having 6 to 20 carbon atoms; R₆ represents a hydroxy group; and R₇ represents a hydrogen atom, a halogen atom, a nitro group, an amino group, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₈ represents a hydrogen atom, or an aryl group or heterocyclic group having 6 to 40 carbon atoms and optionally substituted with a halogen atom, a nitro group, an amino group, or a hydroxy group; R₉ represents a hydrogen atom, or an alkyl group having 1 to 10 carbon atoms, an aryl group having 6 to 40 carbon atoms, or a heterocyclic group optionally substituted with a halogen atom, a nitro group, an amino group or a hydroxy group; and R₈ and R₉ may form a ring with each other. "n6" represents an integer of 1 to "p", "n7" represents an integer of p-n6. Here, "p" is the maximum number of substituents with which the aromatic ring group Ar can be substituted. Note that the symbols in the formula apply only in this formula.

Examples of the resin (B) for forming an organic film used in the present invention include polymers containing a unit structure represented by the following formula (20), disclosed in WO 2010/147155 A1.

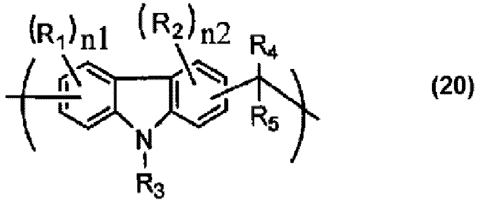

In the formula (20), R₁ and R₂ are each selected from a group consisting of a hydrogen atom, a halogen group, a nitro group, an amino group, a hydroxy group, alkyl groups having 1 to 10 carbon atoms, alkenyl groups having 2 to 10 carbon atoms, aryl groups having 6 to 40 carbon atoms, and combinations thereof, the alkyl groups, the alkenyl groups, or the aryl groups optionally containing an ether bond, a ketone bond, or an ester bond; R₃ is selected from a group consisting of a hydrogen atom, alkyl groups having 1 to 10 carbon atoms, alkenyl groups having 2 to 10 carbon atoms, aryl groups having 6 to 40 carbon atoms, and combinations thereof, the alkyl groups, the alkenyl groups, or the aryl groups optionally containing an ether bond, a ketone bond, or an ester bond; R₄ represents an aryl group or heterocyclic group having 6 to 40 carbon atoms and optionally substituted with a halogen group, a nitro group, an amino group, or a hydroxy group; R₅ represents a hydrogen atom or an alkyl group having 1 to 10 carbon atoms or an aryl group or heterocyclic group having 6 to 40 carbon atoms and optionally substituted with a halogen group, a nitro group, an amino group, or a hydroxy group; R₄ and R₅ optionally form a ring together with the carbon atom bonded to R₄ and R₅; "n1" and "n2" each represent an integer of 1 to 3. Note that the symbols in the formula apply only in this formula.

Examples of the resin (B) for forming an organic film used in the present invention include: novolak resins obtained by a reaction between one or more phenols, such as phenol, cresol, xylenol, catechol, resorcinol, hydroquinone, pyrogallol, hydroxyquinol, and phloroglucinol, and one or more aldehyde sources, such as formaldehyde, paraformaldehyde, and trioxane, in the presence of an acid catalyst; and resins containing a repeating unit structure represented by the following formula (21), disclosed in WO 2012/176767 A1.

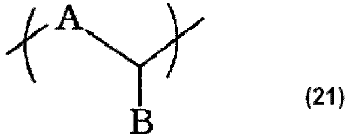

In the formula (21), A represents a hydroxy group-substituted phenylene group derived from polyhydroxybenzene; and B represents monovalent condensed aromatic hydrocarbon ring group in which 2 to 6 benzene rings are condensed. Note that the symbols in the formula apply only in this formula.

Examples of the resin (B) for forming an organic film used in the present invention include novolak resins having a fluorene or tetrahydrospirobiindene structure, disclosed in JP 2005-128509 A, JP 2006-259249 A, JP 2006-259482 A, JP 2006-293298 A, and JP 2007-316282 A, the novolak resins containing a repeating unit structure represented by the following formula (22-1) or (22-2).

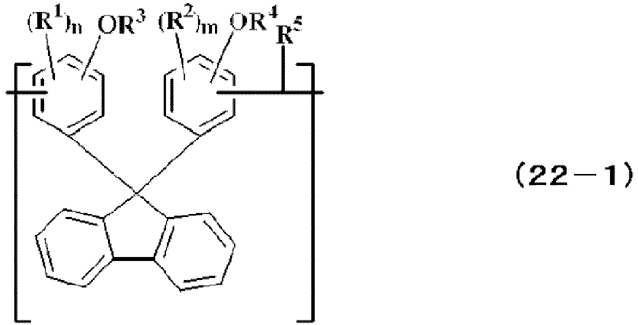

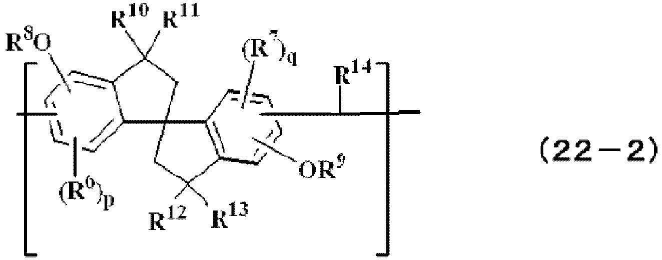

In the formula (22-1) and the formula (22-2), R¹, R², R⁶, and R⁷ each independently represent a hydrogen atom, a linear, branched, or cyclic alkyl group having 1 to 10 carbon atoms, an aryl group having 6 to 10 carbon atoms, an allyl group, or a halogen atom; R³, R⁴, R⁸, and R⁹ each independently represent a hydrogen atom, a linear, branched, or cyclic alkyl group having 1 to 6 carbon atoms, a linear, branched, or cyclic alkenyl group having 2 to 6 carbon atoms, an aryl group having 6 to 10 carbon atoms, or a glycidyl group; and R⁵ and R¹⁴ each independently represent a hydrogen atom, a linear, branched, or cyclic alkyl group having 1 to 10 carbon atoms, or an aryl group having 6 to 10 carbon atoms. "n", "m", "p", and "q" each represent an integer of 1 to 3. R¹⁰ to R¹³ each independently represent a hydrogen atom, a halogen atom, a hydroxy group, a linear, branched, or cyclic alkyl group having 1 to 6 carbon atoms, or a linear, branched, or cyclic alkoxy group having 1 to 6 carbon atoms. Note that the symbols in the formula apply only in this formula.

Examples of the resin (B) for forming an organic film used in the present invention include reaction products obtained by a method disclosed in JP 2012-145897 A. More specific examples include polymers obtained by condensing one or more compounds represented by the following general formula (23-1) and/or (23-2) and one or more compounds represented by the following general formula (24-1) and/or (24-2) and/or an equivalent thereof.

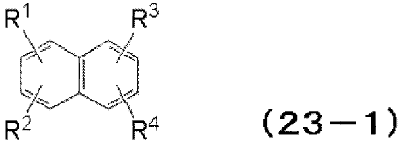

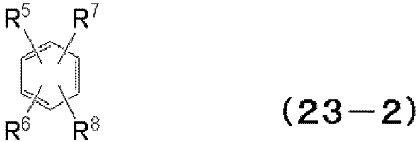

In the general formula (23-1) and the general formula (23-2), R¹ to R⁸ each independently represent a hydrogen atom, a halogen atom, a hydroxy group, an isocyanato group, a glycidyloxy group, a carboxyl group, an amino group, an alkoxy group having 1 to 30 carbon atoms, an alkoxycarbonyl group having 1 to 30 carbon atoms, and an alkanoyloxy group having 1 to 30 carbon atoms, or a saturated or unsaturated organic group having 1 to 30 carbon atoms and optionally being substituted. Furthermore, any two substituents selected from each of R¹ to R⁴ or R⁵ to R⁸ may be bonded to each other within a molecule to form a cyclic substituent. Note that the symbols in the formula apply only in this formula.

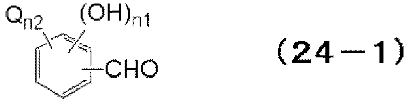

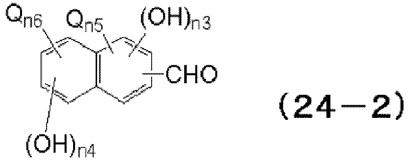

In the general formula (24-1) and the general formula (24-2), Q represents an organic group having 1 to 30 carbon atoms and optionally being substituted, and furthermore, any two Q's selected therefrom are optionally bonded with each other within a molecule to form a cyclic substituent. "n1" to "n6" each represent the number of each substituent, "n1" to "n6" are each 0, 1, or 2, and in the formula (24-1), hydroxybenzaldehyde is excluded. Meanwhile, in the formula (24-2), the relationships 0 ≤ n3+n5 ≤ 3, 0 ≤ n4+n6 ≤ 4, and 1 ≤ n3+n4 ≤ 4 exist. Note that the symbols in the formula apply only in this formula.

Further examples include polymers obtained by condensing one or more compounds represented by the general formula (23-1) and/or (23-2), one or more compounds represented by the general formula (24-1) and/or (24-2) and/or an equivalent thereof, and one or more compounds represented by the following general formula (25) and/or an equivalent thereof.

**Y-CHO** **(25)**

In the formula (25), Y represents a hydrogen atom or a monovalent organic group having 30 or fewer carbon atoms and optionally having a substituent, and the formula (25) is different from the general formula (24-1) and the general formula (24-2). Note that the symbols in the formula apply only in this formula.

Examples of the resin (B) for forming an organic film used in the present invention include compounds containing the following structure, disclosed in JP 2017-119671 A.

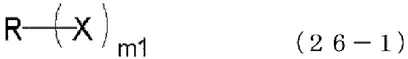

In the formula (26-1), R represents a single bond or an organic group having 1 to 50 carbon atoms; X represents a group represented by any of the following general formulae (26-2); and *"*m1*"* represents an integer that satisfies 2 ≤ m1 ≤ 10. Note that the symbols in the formula apply only in this formula.

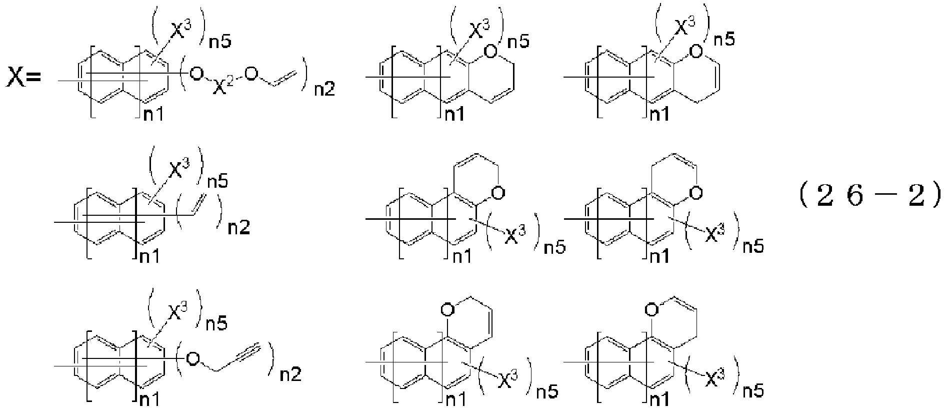

In the formulae, X² represents a divalent organic group having 1 to 10 carbon atoms; "n1" represents 0 or 1; "n2" represents 1 or 2; X³ represents a group represented by the following general formula (26-3); and "n5" represents 0, 1, or 2. Note that the symbols in the formula apply only in this formula.

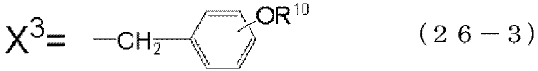

In the formula, R¹⁰ represents a hydrogen atom or a saturated or unsaturated hydrocarbon group having 1 to 10 carbon atoms, and a hydrogen atom on the benzene ring in the formula may be substituted with a methyl group or a methoxy group. Note that the symbols in the formula apply only in this formula.

Examples of the compounds containing the above-described structures include the following compounds.

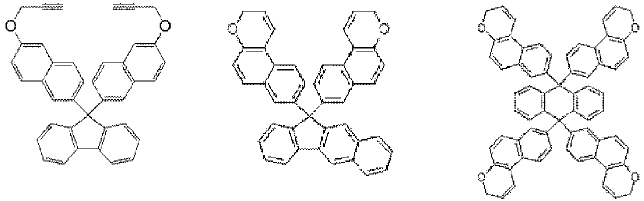

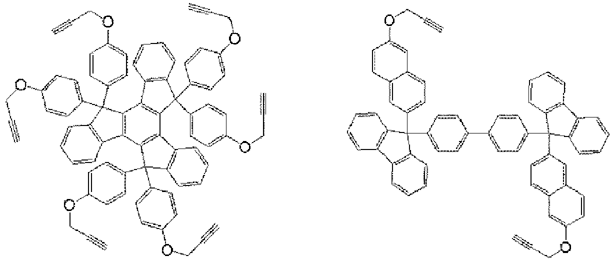

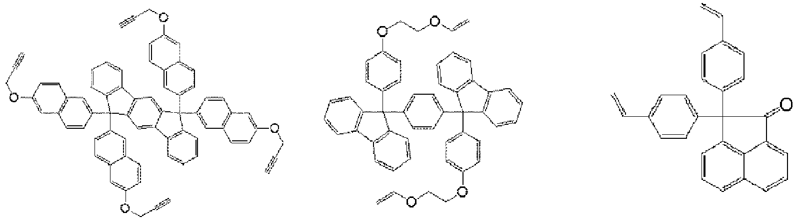

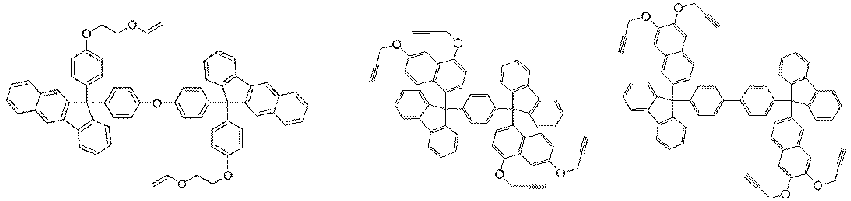

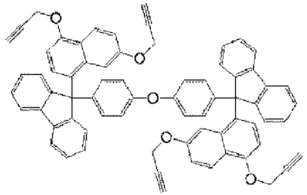

Examples of the resin (B) for forming an organic film used in the present invention include polymers having a repeating unit represented by the following general formula (27-1), disclosed in JP 2019-044022 A.

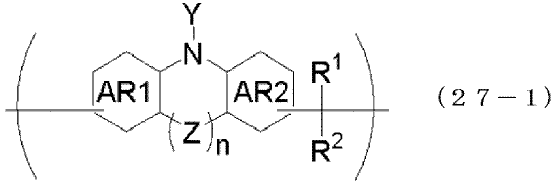

In the formula (27-1), AR1 and AR2 each represent a benzene ring or naphthalene ring optionally having a substituent. R¹ and R² each independently represent a hydrogen atom or an organic group having 1 to 30 carbon atoms, and when R¹ and R² each represent an organic group, R¹ and R² are optionally bonded to each other within a molecule to form a cyclic organic group. "n" represents 0 or 1; when n = 0, AR1 and AR2 do not form a bridged structure between the aromatic rings of AR1 and AR2 via Z; when n = 1, AR1 and AR2 form a bridged structure between the aromatic rings of AR1 and AR2 via Z; and Z represents a single bond or the following formula (27-2). Y represents a group represented by the following formula (27-3). Note that the symbols in the formula apply only in this formula.

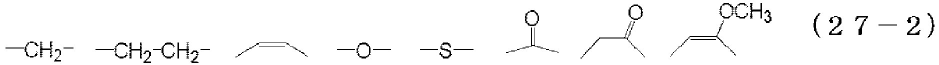

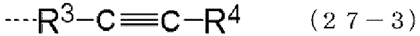

In the formula, R³ represents a single bond or a divalent organic group having 1 to 20 carbon atoms; R⁴ represents a hydrogen atom or a monovalent organic group having 1 to 20 carbon atoms; and a broken line represents an attachment point. Note that the symbols in the formula apply only in this formula.

Examples of the polymers having a repeating unit represented by the general formula (27-1) include the following polymers.

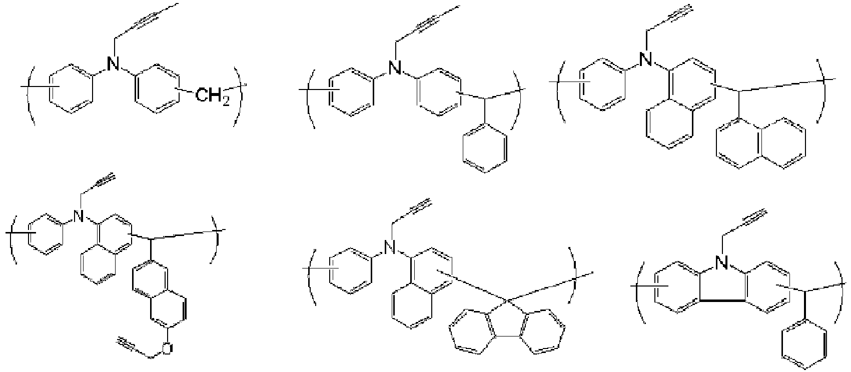

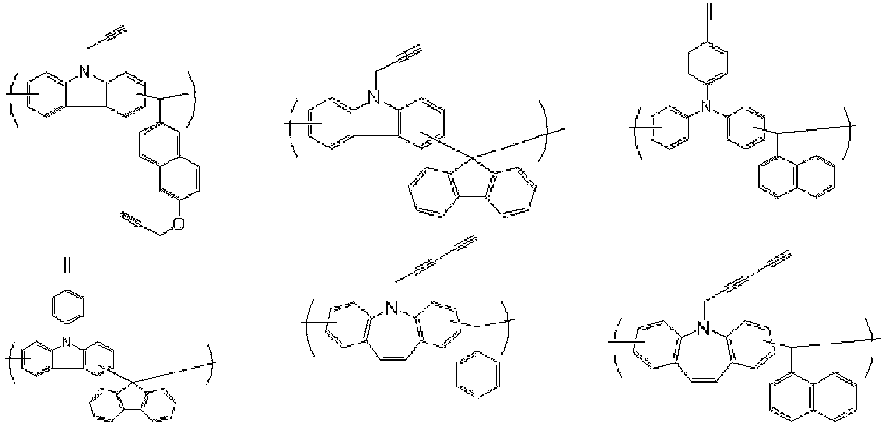

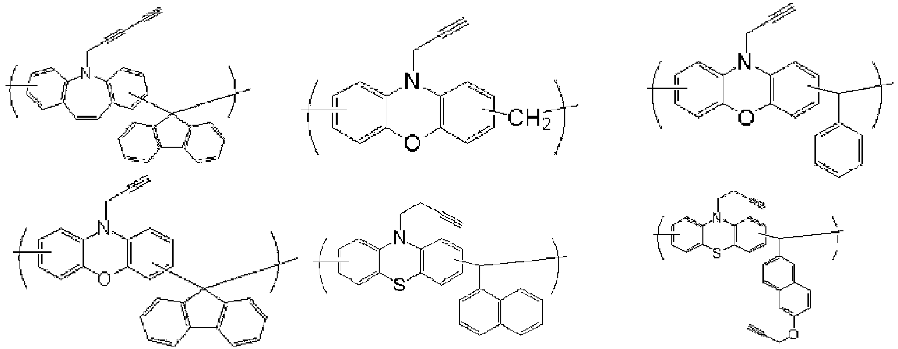

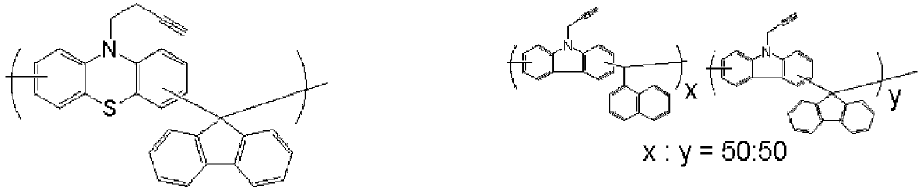

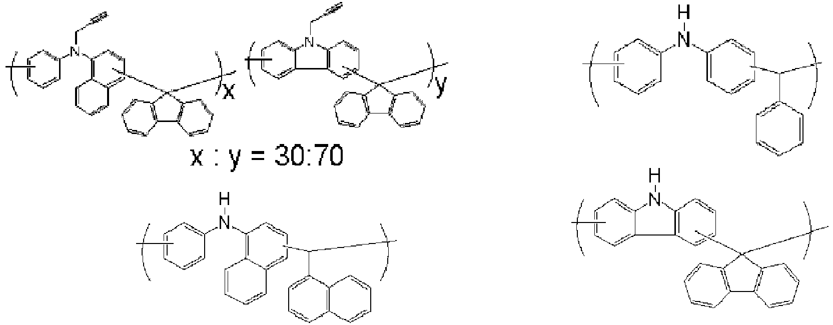

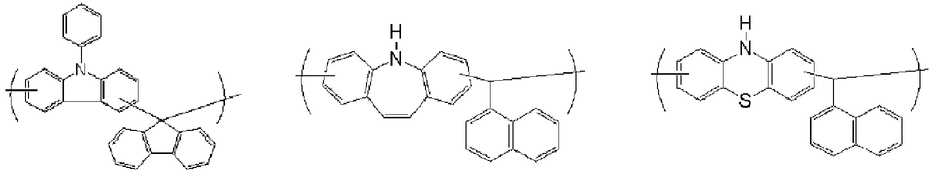

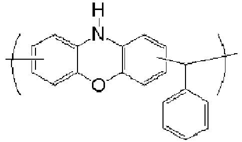

The resin (B) for forming an organic film may be synthesized by a known method, and a commercially available product may be used.

The amount of the resin (B) for forming an organic film to be contained is not particularly limited as long as sufficient film-formability can be achieved on spin-coating with the composition for forming an organic film, but the resin (B) for forming an organic film is preferably contained in an amount of 10 to 40 parts by mass, more preferably 10 to 30 parts by mass, and further preferably 10 to 25 parts by mass, based on 100 parts by mass of the composition for forming an organic film. For example, when a hole or trench, having a very high aspect ratio, of a 3D NAND memory architecture is to be filled with the composition for forming an organic film, the contained amount of the resin for forming an organic film needs to be large. However, on the other hand, such a composition for forming an organic film is highly viscous, and in-plane uniformity after spin-coating and filling property are degraded. Even when the resin (B) for forming an organic film is contained in such a proportion, the inventive composition for forming an organic film makes it possible to form an organic film having excellent in-plane uniformity and excellent filling property, and can therefore be applied suitably.

Meanwhile, the polymer (A) is preferably contained in an amount of 0.01 parts by mass to 5 parts by mass based on 100 parts by mass of the resin (B) for forming an organic film. A composition for forming an organic film containing the polymer in such an amount can provide a formed organic film with better in-plane uniformity.

### [(C) Solvent]

The solvent (C) usable for the inventive composition for forming an organic film is not particularly limited as long as the solvent can dissolve the resin (B) for forming an organic film and the polymer (A), and the solvent can preferably also dissolve the acid generator, crosslinking agent, surfactant, etc. described below. Specific examples include: ketones, such as 2-heptanone, cyclopentanone, and cyclohexanone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, γ-butyrolactone, and propylene glycol mono-tert-butyl ether acetate. One of the solvents may be used, or two or more thereof may be used in mixture. However, the solvent is not limited thereto.

In particular, preferable solvents are propylene glycol monomethyl ether acetate, propylene glycol monomethyl ether, 2-heptanone, cyclopentanone, cyclohexanone, γ-butyrolactone, and mixtures of two or more thereof.

The solvent (C) is preferably contained in an amount of 200 to 10,000 parts by mass, more preferably 300 to 5,000 parts by mass based on 100 parts by mass of the resin (B) for forming an organic film. When the amount is in such a range, the concentration is adjustable in accordance with the desired film thickness.

### [Other Components]

In addition, the inventive composition for forming an organic film can contain an acid generator or a crosslinking agent for further promoting the crosslinking reaction. Acid generators include materials that generate an acid by thermal decomposition and materials that generate an acid by light irradiation, and any acid generator can be contained. Specific examples of the acid generator include those disclosed in paragraphs [0061] to [0085] of JP 2007-199653 A. One kind of the acid generator may be used, or two or more kinds thereof may be used in combination. When the acid generator is contained, the contained amount is preferably 0.05 to 50 parts by mass, more preferably 0.1 to 10 parts by mass based on 100 parts by mass of the resin (B) for forming an organic film. When the amount is as described, it is possible to promote the crosslinking reaction and form a dense film.

Specific examples of the crosslinking agent include those disclosed in paragraphs [0055] to [0060] of JP 2007-199653 A. One kind of the crosslinking agent may be used, or two or more kinds thereof may be used in combination. The crosslinking agent is preferably contained in an amount of 1 to 100 parts by mass, more preferably 5 to 50 parts by mass based on 100 parts by mass of the resin (B) for forming an organic film. When the amount is as described, it is possible to enhance curability and further suppress intermixing with an upper layer film.

The inventive composition for forming an organic film can also contain a surfactant for further improving in-plane uniformity in spin-coating. Specific examples of the surfactant include those disclosed in paragraphs [0142] to [0147] of JP 2009-269953 A. One kind of the surfactant may be used, or two or more kinds thereof may be used in combination. When the surfactant is contained, the contained amount is preferably 0.01 to 10 parts by mass, more preferably 0.05 to 5 parts by mass based on 100 parts by mass of the composition for forming an organic film. When the amount is as described, it is possible to form an organic film excellent in in-plane uniformity.

The inventive composition for forming an organic film can further contain a basic compound for enhancing storage stability. The basic compound serves as a quencher to an acid to prevent a very small amount of acid generated by the acid generator from promoting the crosslinking reaction. Specific examples of such a basic compound include those disclosed in paragraphs [0086] to [0090] of JP 2007-199653 A. One kind of the basic compound may be used, or two or more kinds thereof may be used in combination. When the basic compound is contained, the contained amount is preferably 0.05 to 50 parts by mass, more preferably 0.1 to 10 parts by mass based on 100 parts by mass of the resin (B) for forming an organic film. When the amount is as described, it is possible to improve the storage stability of the composition for forming an organic film.

As described above, the inventive composition for forming an organic film is excellent in hump suppression at the time of an EBR process. Accordingly, the inventive composition for forming an organic film is extremely useful as a resist underlayer film material (organic film material) for multilayer resist processes such as two-layer resist processes, three-layer resist processes using a silicon-containing resist middle layer film or a silicon-containing inorganic hard mask middle layer film, and four-layer resist processes using a silicon-containing resist middle layer film or silicon-containing inorganic hard mask middle layer film and an organic antireflective film or adhesive film.

### [Method for Forming Organic Film]

The present invention provides a method for forming an organic film to be used in a manufacturing process of a semiconductor device, the method including: spin-coating a substrate to be processed with the inventive composition for forming an organic film described above; and forming an organic film by heating the substrate coated with the composition for forming an organic film at a temperature of 100°C or higher and 600°C or lower for 10 to 600 seconds to cure the composition.

In this method for forming an organic film, firstly, the inventive composition for forming an organic film described above is applied onto a substrate to be processed by spin-coating. An excellent filling property can be obtained by using a spin-coating method. After removing a film on an edge portion in an EBR process, baking (heating) is performed in order to promote the crosslinking reaction. Incidentally, the solvent in the composition can be evaporated by this baking, and therefore, mixing can be prevented even when a resist upper layer film or a silicon-containing resist middle layer film is formed on the organic film.

The baking is performed at a temperature of 100°C or higher and 600°C or lower for 10 to 600 seconds, preferably at a temperature of 200°C or higher and 500°C or lower for 10 to 300 seconds. Considering influence on device damage and wafer deformation, the upper limit of the heating temperature in a wafer process of lithography is preferably 600°C or lower, more preferably 500°C or lower. By performing the heat treatment under such conditions, the crosslinking reaction can be promoted, and it is possible to form an organic film that does not mix with a film formed thereon.

### [Patterning Process]

In the following, patterning processes using the inventive composition for forming an organic film will be described.

### [Three-Layer Resist Process Using Silicon-Containing Resist Middle Layer Film]

The present invention provides a patterning process including:
forming an organic film on a body to be processed by using the above-described composition for forming an organic film;
forming a silicon-containing resist middle layer film on the organic film by using a silicon-containing resist middle layer film material;
forming a resist upper layer film on the silicon-containing resist middle layer film by using a resist upper layer film material comprising a photoresist composition;
forming a circuit pattern in the resist upper layer film;
transferring the pattern to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further transferring the pattern to the body to be processed by etching while using the organic film having the transferred pattern as a mask.

The body to be processed is preferably a semiconductor device substrate or the semiconductor device substrate coated with any of a metal film, a metal carbide film, a metal oxide film, a metal nitride film, a metal oxycarbide film, and a metal oxynitride film. The body to be processed is not particularly limited, but more specifically, may be a substrate made of Si, α-Si, p-Si, SiO₂, SiN, SiON, W, TiN, Al, etc.; the substrate coated with the above-mentioned metal film or the like as a layer to be processed; etc.

Examples of the layer to be processed include various Low-k films made of Si, SiO₂, SiON, SiN, p-Si, α-Si, W, W-Si, Al, Cu, Al-Si, or the like; and stopper films thereof. Generally, the layer can be formed to have a thickness of preferably 50 to 10,000 nm, particularly preferably 100 to 5,000 nm. Note that when the layer to be processed is formed, the substrate and the layer to be processed are formed from different materials.

Incidentally, the metal constituting the body to be processed is preferably silicon, titanium, tungsten, hafnium, zirconium, chromium, germanium, copper, silver, gold, aluminum, indium, gallium, arsenic, palladium, iron, tantalum, iridium, molybdenum, or an alloy thereof.

When forming an organic film on the body to be processed by using the inventive composition for forming an organic film, the inventive method for forming an organic film described above can be adopted.

Subsequently, a resist middle layer film (silicon-containing resist middle layer film) is formed on the organic film by using a resist middle layer film material containing a silicon atom. As the resist middle layer film material containing a silicon atom, a polysiloxane-based middle layer film material is preferable. By imparting an antireflective effect to the silicon-containing resist middle layer film, reflection can be suppressed. Particularly, for 193-nm light exposure, a material containing many aromatic groups and having high etching selectivity relative to the substrate is used as a composition for forming an organic film, so that the k-value and thus the substrate reflection are increased; in contrast, the reflection can be suppressed by imparting absorption to the silicon-containing resist middle layer film so as to have an appropriate k-value, and the substrate reflection can be reduced to 0.5% or less. As the silicon-containing resist middle layer film having an antireflective effect, a polysiloxane is preferably used which has anthracene for 248-nm and 157-nm light exposure, or a phenyl group or a light-absorbing group having a silicon-silicon bond for 193-nm light exposure in a pendant structure, and which is crosslinked by an acid or heat.

Subsequently, a resist upper layer film is formed on the silicon-containing resist middle layer film by using a resist upper layer film material containing a photoresist composition. The resist upper layer film material may be a positive type or a negative type, and a photoresist composition that is normally used can be used. After the spin-coating with the resist upper layer film material, pre-baking is preferably performed at 60 to 180°C for 10 to 300 seconds. Then, light exposure, post-exposure baking (PEB), and development are performed according to conventional methods to obtain a resist upper layer film pattern. Note that the thickness of the resist upper layer film is not particularly limited, but is preferably 30 to 500 nm, particularly preferably 50 to 400 nm.

Subsequently, a circuit pattern (resist upper layer film pattern) is formed in the resist upper layer film. The circuit pattern is preferably formed by a lithography using light having a wavelength of 10 nm or more and 300 nm or less, a direct writing with electron beam, nanoimprinting, or a combination thereof.

Examples of exposure light include high-energy beams having a wavelength of 300 nm or less, specifically, deep ultraviolet ray, KrF excimer laser beam (248 nm), ArF excimer laser beam (193 nm), F₂ laser beam (157 nm), Kr₂ laser beam (146 nm), Ar₂ laser beam (126 nm), soft X-ray (EUV) of 3 to 20 nm, electron beam (EB), ion beam, X-ray, etc.

Furthermore, the circuit pattern is preferably developed with an alkaline development or an organic solvent.

Subsequently, the pattern is transferred to the silicon-containing resist middle layer film by etching while using the resist upper layer film having the formed circuit pattern as a mask. The etching of the silicon-containing resist middle layer film performed while using the resist upper layer film pattern as a mask is preferably performed by using a fluorocarbon-based gas. Thus, a silicon-containing resist middle layer film pattern is transferred.

Subsequently, the pattern is transferred to the organic film by etching while using the silicon-containing resist middle layer film having the transferred pattern as a mask. The silicon-containing resist middle layer film exhibits etching resistance to oxygen gas or hydrogen gas, and therefore, the etching of the organic film performed while using the silicon-containing resist middle layer film pattern as a mask is preferably performed by using an etching gas mainly containing oxygen gas or hydrogen gas. Thus, an organic film pattern is transferred.

Subsequently, the pattern is transferred to the body to be processed by etching while using the organic film having the transferred pattern as a mask. This etching of the body to be processed (layer to be processed) can be performed by a conventional method. For example, a body to be processed made of SiO₂, SiN, or silica low-dielectric insulating film is etched mainly with a fluorocarbon-based gas; and a body to be processed made of p-Si, Al, or W is etched mainly with a chlorine- or bromine-based gas. When the substrate is processed by etching with a fluorocarbon-based gas, the silicon-containing resist underlayer film pattern is removed when the substrate is processed. Meanwhile, when the substrate is processed by etching with a chlorine- or bromine-based gas, the silicon-containing resist underlayer film pattern needs to be removed by additional dry etching with a fluorocarbon-based gas after the substrate processing.

The organic film obtained by using the inventive composition for forming an organic film can be provided with excellent etching resistance when the body to be processed is etched as described above.

### [Four-Layer Resist Process Using Silicon-Containing Resist Middle Layer Film and Organic Antireflective Film or Adhesive Film]

The present invention also provides a patterning process including:
forming an organic film on a body to be processed by using the above-described composition for forming an organic film;
forming a silicon-containing resist middle layer film on the organic film by using a silicon-containing resist middle layer film material;
forming an organic antireflective film or an adhesive film on the silicon-containing resist middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further transferring the pattern to the body to be processed by etching while using the organic film having the transferred pattern as a mask.

This method can be performed in the same manner as the three-layer resist process using the silicon-containing resist middle layer film, except that the organic antireflective film (BARC) or the adhesive film is formed between the silicon-containing resist middle layer film and the resist upper layer film.

The organic antireflective film and the adhesive film can be formed by spin-coating by using a known organic antireflective film material.

### [Three-Layer Resist Process Using Inorganic Hard Mask Middle Layer Film]

The present invention also provides a patterning process including:
forming an organic film on a body to be processed by using the above-described composition for forming an organic film;
forming an inorganic hard mask middle layer film selected from a silicon oxide film, a silicon nitride film, and a silicon oxynitride film on the organic film;
forming a resist upper layer film on the inorganic hard mask middle layer film by using a resist upper layer film material comprising a photoresist composition;
forming a circuit pattern in the resist upper layer film;
transferring the pattern to the inorganic hard mask middle layer film by etching while using the resist upper layer film having the formed circuit pattern as a mask;
transferring the pattern to the organic film by etching while using the inorganic hard mask middle layer film having the transferred pattern as a mask; and
further transferring the pattern to the body to be processed by etching while using the organic film having the transferred pattern as a mask.

This method can be performed in the same manner as the three-layer resist process using the silicon-containing resist middle layer film, except that the inorganic hard mask middle layer film is formed instead of the silicon-containing resist middle layer film on the organic film.

The inorganic hard mask middle layer film selected from a silicon oxide film, a silicon nitride film, and a silicon oxynitride film (SiON film) can be formed by a CVD method, an ALD method, etc. Methods for forming the silicon nitride film are, for example, disclosed in JP 2002-334869 A, WO 2004/066377 A1, etc. The inorganic hard mask middle layer film preferably has a thickness of 5 to 200 nm, more preferably 10 to 100 nm. As the inorganic hard mask middle layer film, a SiON film, which has a high function as an antireflective film, is the most preferably used.

### [Four-Layer Resist Process Using Inorganic Hard Mask Middle Layer Film and Organic Antireflective Film or Adhesive Film]

The present invention also provides a patterning process including:
forming an organic film on a body to be processed by using the above-described composition for forming an organic film;
forming an inorganic hard mask middle layer film selected from a silicon oxide film, a silicon nitride film, and a silicon oxynitride film on the organic film;
forming an organic antireflective film or an adhesive film on the inorganic hard mask middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and the inorganic hard mask middle layer film by etching while using the resist upper layer film having the formed circuit pattern as a mask;
transferring the pattern to the organic film by etching while using the inorganic hard mask middle layer film having the transferred pattern as a mask; and
further transferring the pattern to the body to be processed by etching while using the organic film having the transferred pattern as a mask.

This method can be performed in the same manner as the three-layer resist method using the inorganic hard mask middle layer film, except that the organic antireflective film (BARC) or the adhesive film is formed between the inorganic hard mask middle layer film and the resist upper layer film.

Particularly, when a SiON film is used as the inorganic hard mask middle layer film, two antireflective films including the SiON film and the BARC make it possible to suppress the reflection even in liquid immersion exposure at a high NA exceeding 1.0. Another merit of forming the BARC is having an effect of reducing trailing of the resist upper layer film pattern immediately above the SiON film.

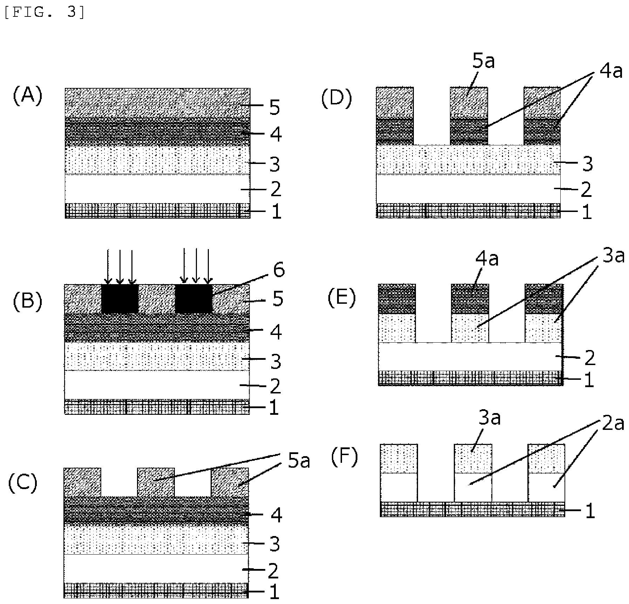

Here, an example of the inventive patterning processes according to a three-layer resist process is shown in FIG. 3(A) to (F). In the case of a three-layer resist process, as shown in FIG. 3(A), an organic film 3 is formed by using the inventive composition for forming an organic film on a layer 2 to be processed formed on a substrate 1; then, a silicon-containing resist middle layer film 4 is formed; and a resist upper layer film 5 is formed thereon. Next, as shown in FIG. 3(B), an exposure portion 6 of the resist upper layer film 5 is exposed, and PEB (post-exposure baking) is performed. Next, as shown in FIG. 3(C), development is performed to form a resist upper layer film pattern 5a. Next, as shown in FIG. 3(D), a silicon-containing resist middle layer film 4 is dry-etched by using a fluorocarbon-based gas while using the resist upper layer film pattern 5a as a mask, and thus, a silicon-containing resist middle layer film pattern 4a is formed. Next, as shown in FIG. 3(E), the resist upper layer film pattern 5a is removed, then the organic film 3 is etched with oxygen plasma while using the silicon-containing resist middle layer film pattern 4a as a mask, and thus, an organic film pattern 3a is formed. Furthermore, as shown in FIG. 3(F), the silicon-containing resist middle layer film pattern 4a is removed, then the layer 2 to be processed is etched while using the organic film pattern 3a as a mask, and thus, a pattern 2a is formed. By humps being suppressed when the organic film is formed, it is possible to reduce defects that are generated due to humps of the organic film during the dry etching of FIG. 3(D), (E), and (F).

In a case where an inorganic hard mask middle layer film is formed, the silicon-containing resist middle layer film 4 can be changed to an inorganic hard mask middle layer film, and in a case where a BARC or an adhesive film is formed, the BARC or the adhesive film can be formed between the silicon-containing resist middle layer film 4 and the resist upper layer film 5. The etching of the BARC or the adhesive film may be performed continuously before the etching of the silicon-containing resist middle layer film 4; alternatively, after the BARC or the adhesive film alone is etched, the etching apparatus may be changed and so forth, and then the etching of the silicon-containing resist middle layer film 4 may be performed.

As described above, the inventive patterning processes make it possible to form a fine pattern in a body to be processed with high precision according to a multilayer resist process, and to suppress hump formation on an organic film, thus reducing defects derived from humps of the organic film.

### EXAMPLES

Hereinafter, the present invention will be further specifically described with reference to Synthesis Examples, Comparative Synthesis Examples, Examples, and Comparative Examples. However, the present invention is not limited thereto. Note that, specifically, the molecular weight was measured in the following manner. Weight-average molecular weight (Mw) and number-average molecular weight (Mn) on polystyrene basis were measured by gel permeation chromatography (GPC) using tetrahydrofuran as an eluent (solvent), and dispersity (Mw/Mn) was calculated therefrom.

### [Synthesis of Polymers (A1) to (A8)]

For the synthesis of polymers (A1) to (A8), used for the preparation of compositions for forming an organic film, octafluorocyclopentene and, as diol, alcohol, and carboxylic acid components, the following compounds (a1) to (a10) were used.

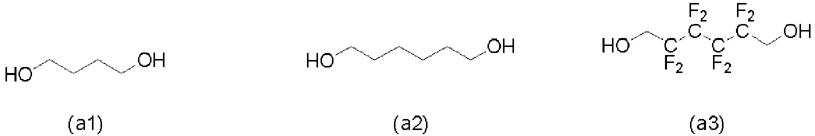

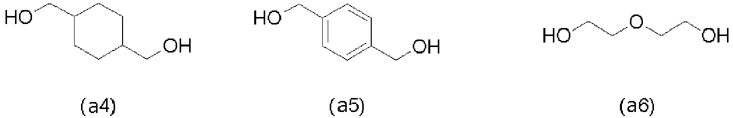

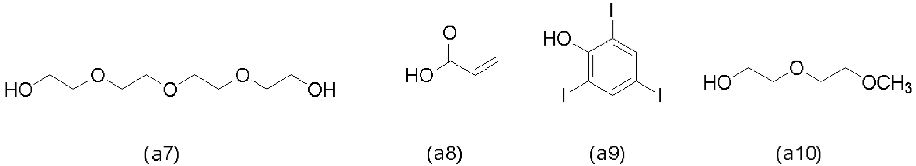

### [Synthesis Example 1] Synthesis of Polymer (A1)

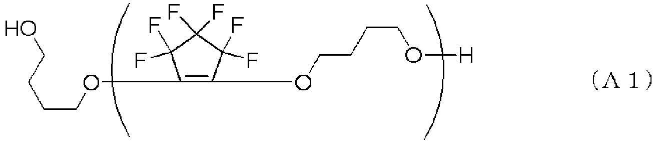

Under a nitrogen atmosphere, 4.67 g of the compound (a1) and 50.0 g of THF (tetrahydrofuran) were stirred in an ice bath to form a homogeneous solution, then 2.72 g of sodium hydride was added, and the mixture was stirred for 1 hour. After that, a mixed solution of 10.0 g of octafluorocyclopentene and 10.0 g of THF was added dropwise over 20 minutes, and a reaction was allowed to take place at room temperature for 24 hours. After the reaction, 50 g of pure water was added dropwise to quench the reaction. Then, 100 ml of MIBK was added, and the separated lower layer was removed. The product was washed twice with 50 g of a 3.0% aqueous nitric acid solution and five times with 50 g of pure water in this order, and the organic layer was evaporated under reduced pressure to dryness. To the residue, 50 g of THF was added, and 200 g of hexane was added dropwise while stirring to precipitate a cake-like precipitate. After leaving the resulting product to stand for some time, the transparent supernatant liquid was decanted. 50 g of THF was added again to form a homogeneous solution, and 200 g of hexane was added to precipitate a cake-like precipitate. After leaving the resulting product to stand, the supernatant liquid was decanted. To the residue, PGMEA (propylene glycol monomethyl ether acetate) was added, and distillation under reduced pressure and concentration adjustment were performed. Thus, a polymer (A1) was obtained as a PGMEA solution having a polymer concentration of 30 wt%.

The weight-average molecular weight (Mw) and the dispersity (Mw/Mn) were determined by GPC, and the following results were obtained.
(A1): Mw=6,700, Mw/Mn=2.34

### [Synthesis Example 2] Synthesis of Polymer (A2)

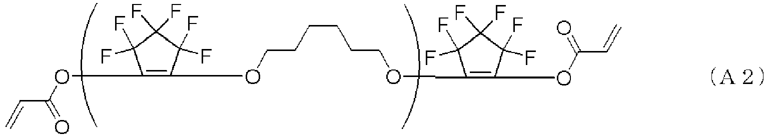

Under a nitrogen atmosphere, 5.02 g of the compound (a2) and 50.0 g of THF (tetrahydrofuran) were stirred in an ice bath to form a homogeneous solution, then 2.72 g of sodium hydride was added, and the mixture was stirred for 1 hour. After that, a mixed solution of 10.0 g of octafluorocyclopentene and 10.0 g of THF was added dropwise over 20 minutes, and a reaction was allowed to take place at room temperature for 16 hours. Then, 1.02 g of the compound (a8) was added dropwise, and a reaction was further allowed to take place for 8 hours. After the reaction, 50 g of pure water was added dropwise to quench the reaction. Then, 100 ml of MIBK was added, and the separated lower layer was removed. The product was washed once with 50 g of a 3.0% aqueous sodium hydrogencarbonate solution, three times with 50 g of a 3.0% aqueous nitric acid solution, and five times with 100 g of pure water in this order, and the organic layer was evaporated under reduced pressure to dryness. To the residue, 50 g of THF was added, and 200 g of hexane was added dropwise while stirring to precipitate a cake-like precipitate. After leaving the resulting product to stand for some time, the transparent supernatant liquid was decanted. 50 g of THF was added again to form a homogeneous solution, and 200 g of hexane was added to precipitate a cake-like precipitate. After leaving the resulting product to stand, the supernatant liquid was decanted. To the residue, PGMEA (propylene glycol monomethyl ether acetate) was added, and distillation under reduced pressure and concentration adjustment were performed. Thus, a polymer (A2) was obtained as a PGMEA solution having a polymer concentration of 30 wt%.

The weight-average molecular weight (Mw) and the dispersity (Mw/Mn) were determined by GPC, and the following results were obtained.
(A2): Mw=8,600, Mw/Mn=2.76

### [Synthesis Example 3] Synthesis of Polymer (A3)

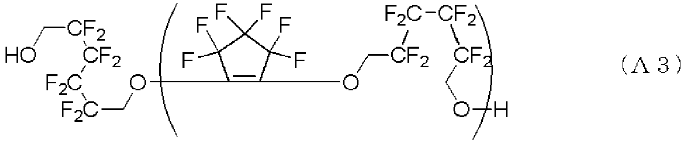

Under a nitrogen atmosphere, 13.60 g of the compound (a3) and 50.0 g of THF (tetrahydrofuran) were stirred in an ice bath to form a homogeneous solution, then 2.72 g of sodium hydride was added, and the mixture was stirred for 1 hour. After that, a mixed solution of 10.0 g of octafluorocyclopentene and 10.0 g of THF was added dropwise over 20 minutes, and a reaction was allowed to take place at room temperature for 24 hours. After the reaction, 50 g of pure water was added dropwise to quench the reaction. Then, 100 ml of MIBK was added, and the separated lower layer was removed. The product was washed twice with 50 g of a 3.0% aqueous nitric acid solution and five times with 50 g of pure water in this order, and the organic layer was evaporated under reduced pressure to dryness. To the residue, 50 g of THF was added, and 200 g of hexane was added dropwise while stirring to precipitate a cake-like precipitate. After leaving the resulting product to stand for some time, the transparent supernatant liquid was decanted. 50 g of THF was added again to form a homogeneous solution, and 200 g of hexane was added to precipitate a cake-like precipitate. After leaving the resulting product to stand, the supernatant liquid was decanted. To the residue, PGMEA (propylene glycol monomethyl ether acetate) was added, and distillation under reduced pressure and concentration adjustment were performed. Thus, a polymer (A3) was obtained as a PGMEA solution having a polymer concentration of 30 wt%.

The weight-average molecular weight (Mw) and the dispersity (Mw/Mn) were determined by GPC, and the following results were obtained.
(A3): Mw=12,800, Mw/Mn=3.21

### [Synthesis Example 4] Synthesis of Polymer (A4)

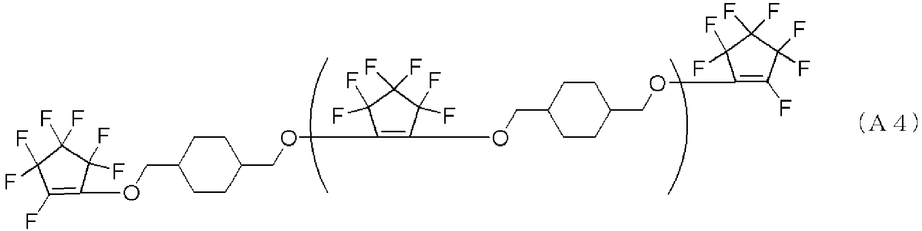

Under a nitrogen atmosphere, 6.12 g of the compound (a4) and 50.0 g of THF (tetrahydrofuran) were stirred in an ice bath to form a homogeneous solution, then 2.72 g of sodium hydride was added, and the mixture was stirred for 1 hour. After that, a mixed solution of 10.0 g of octafluorocyclopentene and 10.0 g of THF was added dropwise over 20 minutes, and a reaction was allowed to take place at room temperature for 24 hours. After the reaction, 50 g of pure water was added dropwise to quench the reaction. Then, 100 ml of MIBK was added, and the separated lower layer was removed. The product was washed twice with 50 g of a 3.0% aqueous nitric acid solution and five times with 50 g of pure water in this order, and the organic layer was evaporated under reduced pressure to dryness. To the residue, 50 g of THF was added, and 200 g of hexane was added dropwise while stirring to precipitate a cake-like precipitate. After leaving the resulting product to stand for some time, the transparent supernatant liquid was decanted. 50 g of THF was added again to form a homogeneous solution, and 200 g of hexane was added to precipitate a cake-like precipitate. After leaving the resulting product to stand, the supernatant liquid was decanted. To the residue, PGMEA (propylene glycol monomethyl ether acetate) was added, and distillation under reduced pressure and concentration adjustment were performed. Thus, a polymer (A4) was obtained as a PGMEA solution having a polymer concentration of 30 wt%.

The weight-average molecular weight (Mw) and the dispersity (Mw/Mn) were determined by GPC, and the following results were obtained.
(A4): Mw=14,500, Mw/Mn=2.81

### [Synthesis Example 5] Synthesis of Polymer (A5)

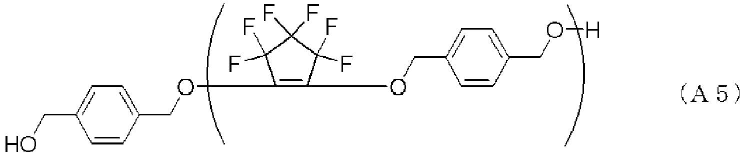

Under a nitrogen atmosphere, 7.17 g of the compound (a5) and 50.0 g of THF (tetrahydrofuran) were stirred in an ice bath to form a homogeneous solution, then 2.72 g of sodium hydride was added, and the mixture was stirred for 1 hour. After that, a mixed solution of 10.0 g of octafluorocyclopentene and 10.0 g of THF was added dropwise over 20 minutes, and a reaction was allowed to take place at room temperature for 24 hours. After the reaction, 50 g of pure water was added dropwise to quench the reaction. Then, 100 ml of MIBK was added, and the separated lower layer was removed. The product was washed twice with 50 g of a 3.0% aqueous nitric acid solution and five times with 50 g of pure water in this order, and the organic layer was evaporated under reduced pressure to dryness. To the residue, 50 g of THF was added, and 200 g of hexane was added dropwise while stirring to precipitate a cake-like precipitate. After leaving the resulting product to stand for some time, the transparent supernatant liquid was decanted. 50 g of THF was added again to form a homogeneous solution, and 200 g of hexane was added to precipitate a cake-like precipitate. After leaving the resulting product to stand, the supernatant liquid was decanted. To the residue, PGMEA (propylene glycol monomethyl ether acetate) was added, and distillation under reduced pressure and concentration adjustment were performed. Thus, a polymer (A5) was obtained as a PGMEA solution having a polymer concentration of 30 wt%.

The weight-average molecular weight (Mw) and the dispersity (Mw/Mn) were determined by GPC, and the following results were obtained.
(A5): Mw=13,000, Mw/Mn=1.94

### [Synthesis Example 6] Synthesis of Polymer (A6)

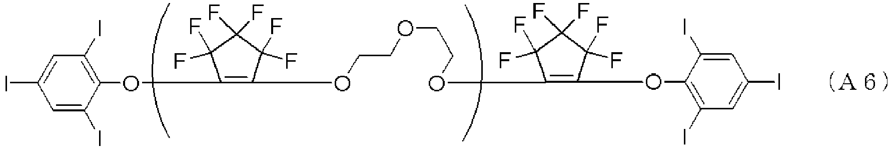

Under a nitrogen atmosphere, 4.50 g of the compound (a6) and 50.0 g of THF (tetrahydrofuran) were stirred in an ice bath to form a homogeneous solution, then 2.72 g of sodium hydride was added, and the mixture was stirred for 1 hour. After that, a mixed solution of 10.0 g of octafluorocyclopentene and 10.0 g of THF was added dropwise over 20 minutes, and a reaction was allowed to take place at room temperature for 16 hours. Then, 6.67 g of the compound (a9) was added dropwise, and a reaction was further allowed to take place for 8 hours. After the reaction, 50 g of pure water was added dropwise to quench the reaction. Then, 100 ml of MIBK was added, and the separated lower layer was removed. The product was washed twice with 50 g of a 3.0% aqueous sodium hydroxide solution, three times with 50 g of a 3.0% aqueous nitric acid solution, and five times with 100 g of pure water in this order, and the organic layer was evaporated under reduced pressure to dryness. To the residue, 50 g of THF was added, and 200 g of hexane was added dropwise while stirring to precipitate a cake-like precipitate. After leaving the resulting product to stand for some time, the transparent supernatant liquid was decanted. 50 g of THF was added again to form a homogeneous solution, and 200 g of hexane was added to precipitate a cake-like precipitate. After leaving the resulting product to stand, the supernatant liquid was decanted. To the residue, PGMEA (propylene glycol monomethyl ether acetate) was added, and distillation under reduced pressure and concentration adjustment were performed. Thus, a polymer (A6) was obtained as a PGMEA solution having a polymer concentration of 30 wt%.

The weight-average molecular weight (Mw) and the dispersity (Mw/Mn) were determined by GPC, and the following results were obtained.
(A6): Mw=11,100, Mw/Mn=2.75

### [Synthesis Example 7] Synthesis of Polymer (A7)

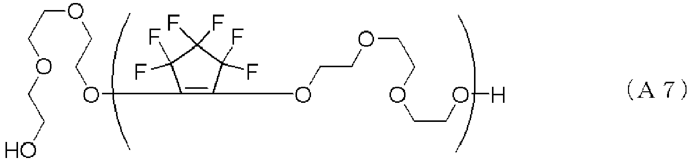

Under a nitrogen atmosphere, 10.08 g of the compound (a7) and 50.0 g of THF (tetrahydrofuran) were stirred in an ice bath to form a homogeneous solution, then 2.72 g of sodium hydride was added, and the mixture was stirred for 1 hour. After that, a mixed solution of 10.0 g of octafluorocyclopentene and 10.0 g of THF was added dropwise over 20 minutes, and a reaction was allowed to take place at room temperature for 24 hours. After the reaction, 50 g of pure water was added dropwise to quench the reaction. Then, 100 ml of MIBK was added, and the separated lower layer was removed. The product was washed twice with 50 g of a 3.0% aqueous nitric acid solution and five times with 50 g of pure water in this order, and the organic layer was evaporated under reduced pressure to dryness. To the residue, 50 g of THF was added, and 200 g of hexane was added dropwise while stirring to precipitate a cake-like precipitate. After leaving the resulting product to stand for some time, the transparent supernatant liquid was decanted. 50 g of THF was added again to form a homogeneous solution, and 200 g of hexane was added to precipitate a cake-like precipitate. After leaving the resulting product to stand, the supernatant liquid was decanted. To the residue, PGMEA (propylene glycol monomethyl ether acetate) was added, and distillation under reduced pressure and concentration adjustment were performed. Thus, a polymer (A7) was obtained as a PGMEA solution having a polymer concentration of 30 wt%.

The weight-average molecular weight (Mw) and the dispersity (Mw/Mn) were determined by GPC, and the following results were obtained.
(A7): Mw=9,700, Mw/Mn=2.19

### [Synthesis Example 8] Synthesis of Polymer (A8)

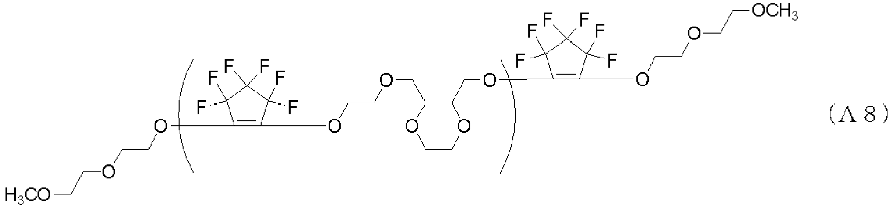

Under a nitrogen atmosphere, 8.24 g of the compound (a7) and 50.0 g of THF (tetrahydrofuran) were stirred in an ice bath to form a homogeneous solution, then 2.72 g of sodium hydride was added, and the mixture was stirred for 1 hour. After that, a mixed solution of 10.0 g of octafluorocyclopentene and 10.0 g of THF was added dropwise over 20 minutes, and a reaction was allowed to take place at room temperature for 16 hours. Then, 1.70 g of the compound (a10) was added dropwise, and a reaction was further allowed to take place for 8 hours. After the reaction, 50 g of pure water was added dropwise to quench the reaction. Then, 100 ml of MIBK was added, and the separated lower layer was removed. The product was washed three times with 50 g of a 2.0% aqueous nitric acid solution and five times with 100 g of pure water in this order, and the organic layer was evaporated under reduced pressure to dryness. To the residue, 50 g of THF was added, and 200 g of hexane was added dropwise while stirring to precipitate a cake-like precipitate. After leaving the resulting product to stand for some time, the transparent supernatant liquid was decanted. 50 g of THF was added again to form a homogeneous solution, and 200 g of hexane was added to precipitate a cake-like precipitate. After leaving the resulting product to stand, the supernatant liquid was decanted. To the residue, PGMEA (propylene glycol monomethyl ether acetate) was added, and distillation under reduced pressure and concentration adjustment were performed. Thus, a polymer (A8) was obtained as a PGMEA solution having a polymer concentration of 30 wt%.

The weight-average molecular weight (Mw) and the dispersity (Mw/Mn) were determined by GPC, and the following results were obtained.
(A8): Mw=10,200, Mw/Mn=3.04

### [Synthesis of Comparative Polymers (R1) to (R5)]

For the synthesis of comparative polymers (R1) to (R5), used for the preparation of compositions for forming an organic film, the following monomers (r1) to (r6) were used.

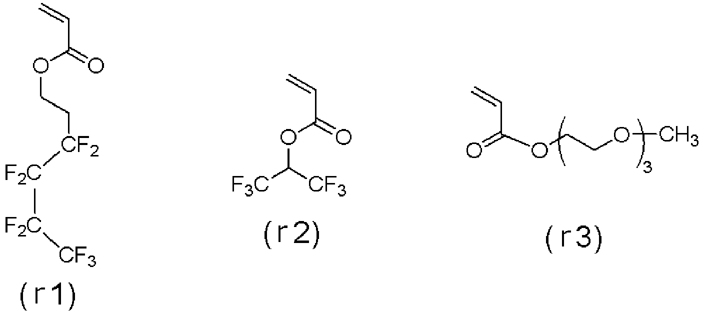

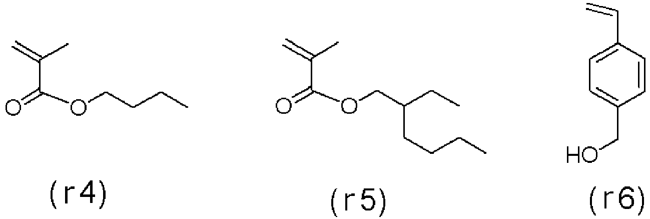

### [Comparative Synthesis Example 1] Synthesis of Comparative Polymer (R1)

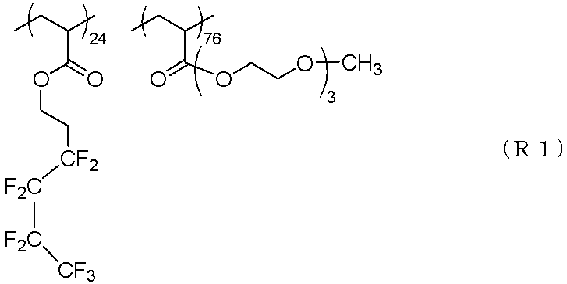

Under a nitrogen atmosphere, 6.0 g of propylene glycol monomethyl ether acetate (PGMEA) was heated and stirred at 80°C. A mixture of 3.44 g (0.011 mol) of the monomer (r1), 7.46 g (0.034 mol) of the monomer (r3), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a PGMEA solution of the target comparative polymer (R1) was obtained.

The weight-average molecular weight (Mw) and the dispersity (Mw/Mn) were determined by GPC, and the following results were obtained.
(R1): Mw=9,500, Mw/Mn=1.20

### [Comparative Synthesis Example 2] Synthesis of Comparative Polymer (R2)

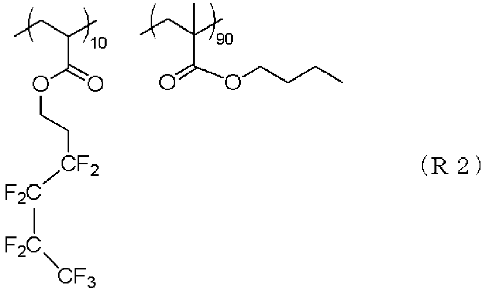

Under a nitrogen atmosphere, 6.0 g of propylene glycol monomethyl ether acetate (PGMEA) was heated and stirred at 80°C. A mixture of 1.43 g (0.005 mol) of the monomer (r1), 5.76 g (0.041 mol) of the monomer (r4), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a PGMEA solution of the target comparative polymer (R2) was obtained.

The weight-average molecular weight (Mw) and the dispersity (Mw/Mn) were determined by GPC, and the following results were obtained.
(R2): Mw=5,800, Mw/Mn=1.42

### [Comparative Synthesis Example 3] Synthesis of Comparative Polymer (R3)

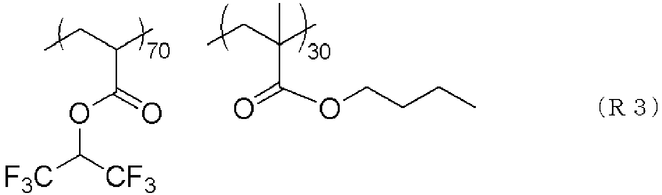

Under a nitrogen atmosphere, 6.0 g of propylene glycol monomethyl ether acetate (PGMEA) was heated and stirred at 80°C. A mixture of 7.00 g (0.032 mol) of the monomer (r2), 1.92 g (0.014 mol) of the monomer (r4), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a PGMEA solution of the target comparative polymer (R3) was obtained.

The weight-average molecular weight (Mw) and the dispersity (Mw/Mn) were determined by GPC, and the following results were obtained.
(R3): Mw=6,200, Mw/Mn=1.33

### [Comparative Synthesis Example 4] Synthesis of Comparative Polymer (R4)

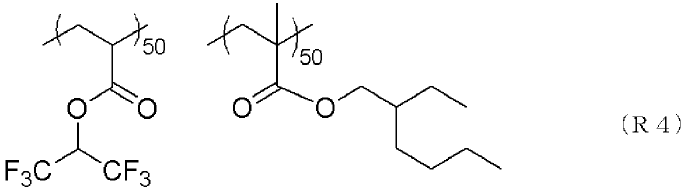

Under a nitrogen atmosphere, 6.0 g of propylene glycol monomethyl ether acetate (PGMEA) was heated and stirred at 80°C. A mixture of 5.00 g (0.023 mol) of the monomer (r2), 3.20 g (0.023 mol) of the monomer (r5), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a PGMEA solution of the target comparative polymer (R4) was obtained.

The weight-average molecular weight (Mw) and the dispersity (Mw/Mn) were determined by GPC, and the following results were obtained.
(R4): Mw=8,300, Mw/Mn=1.33

### [Comparative Synthesis Example 5] Synthesis of Comparative Polymer (R5)

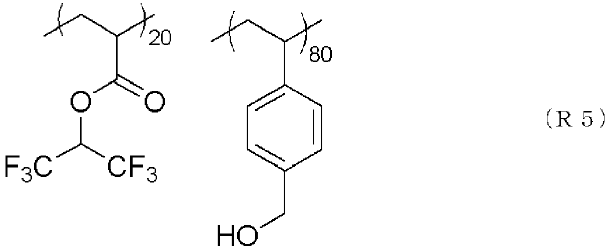

Under a nitrogen atmosphere, 6.0 g of propylene glycol monomethyl ether acetate (PGMEA) was heated and stirred at 80°C. A mixture of 2.00 g (0.009 mol) of the monomer (r2), 5.41 g (0.036 mol) of the monomer (r6), 0.473 g of dimethyl 2,2-azobis(2-methylpropionate), and 34 g of PGMEA was added dropwise thereto over 4 hours. The mixture was further heated and stirred for 16 hours, and then cooled to room temperature. Thus, a PGMEA solution of the target comparative polymer (R5) was obtained.

The weight-average molecular weight (Mw) and the dispersity (Mw/Mn) were determined by GPC, and the following results were obtained.
(R5): Mw=3,800, Mw/Mn=1.44

The structural formula, weight-average molecular weight (Mw), and dispersity (Mw/Mn) of the polymers (A1) to (A8) obtained above are listed in Tables 1 and 2. The structural formula, Mw, and Mw/Mn of the comparative polymers (R1) to (R5), used in the Comparative Examples, are shown in Table 3.

**[Table 1]**

| Synthesis Example | Polymer | Mw | Mw/Mn |
|---|---|---|---|
| 1 | 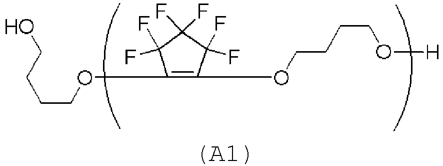 | 6,700 | 2.34 |
| 2 | 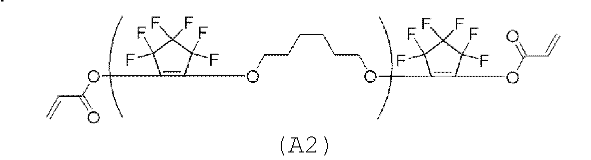 | 8,600 | 2.76 |
| 3 | 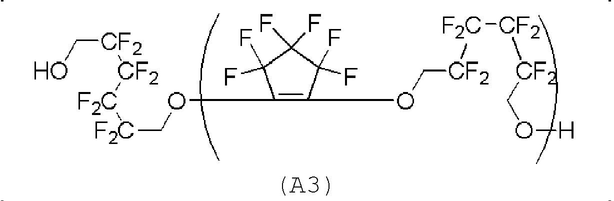 | 12,800 | 3.21 |
| 4 | 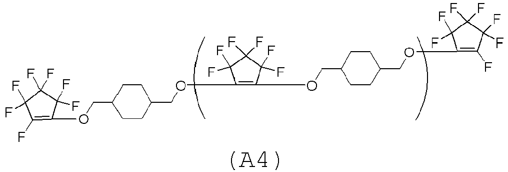 | 14,500 | 2.81 |

**[Table 2]**

| Synthesis Example | Polymer | Mw | Mw/Mn |
|---|---|---|---|
| 5 | 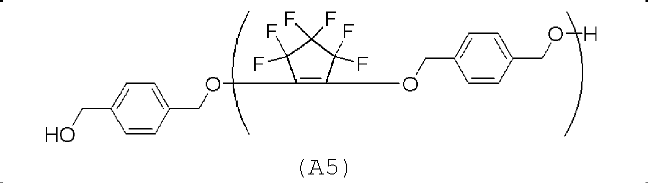 | 13,000 | 1.94 |
| 6 | 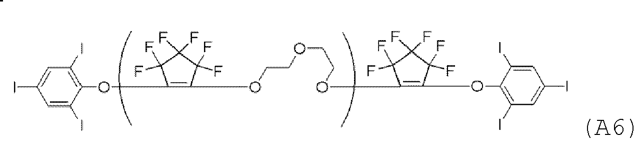 | 11,100 | 2.75 |
| 7 | 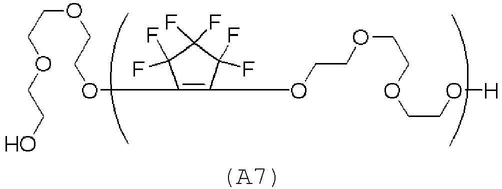 | 9,700 | 2.19 |
| 8 | 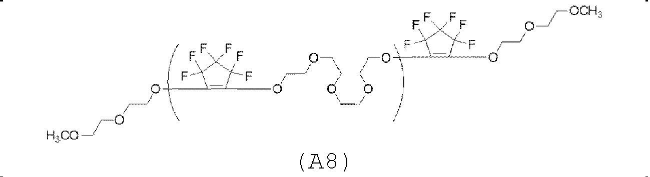 | 10,200 | 3.04 |

**[Table 3]**

| Comparative Synthesis Example | Comparative polymer | Mw | Mw/Mn |
|---|---|---|---|
| 1 | 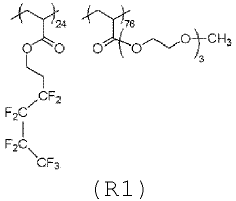 | 9, 500 | 1.20 |
| 2 | 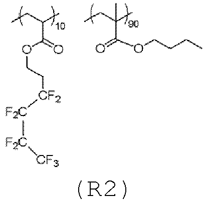 | 5, 800 | 1.42 |
| 3 | 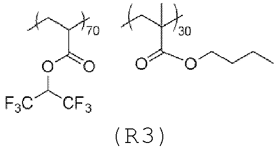 | 6, 200 | 1.33 |
| 4 | 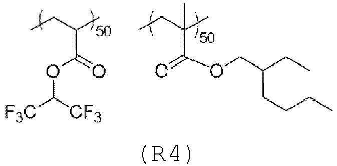 | 8, 300 | 1.33 |
| 5 | 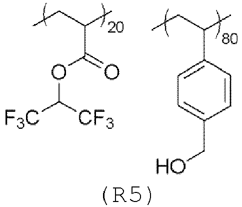 | 3, 800 | 1.44 |

### [Resins for Forming Organic Film]

B1: a resin represented by the following formula (B1)
B2: a resin represented by the following formula (B2)
B3: a compound represented by the following formula (B3)
B4: a compound represented by the following formula (B4)
B5: a resin represented by the following formula (B5)
B6: a resin represented by the following formula (B6)

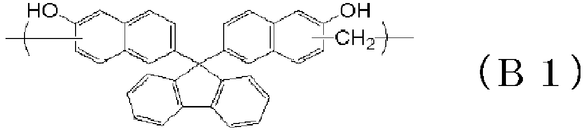

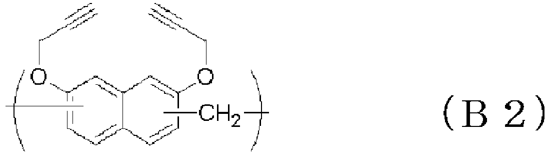

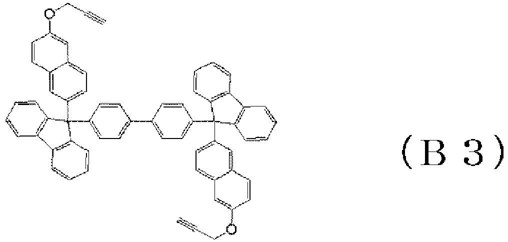

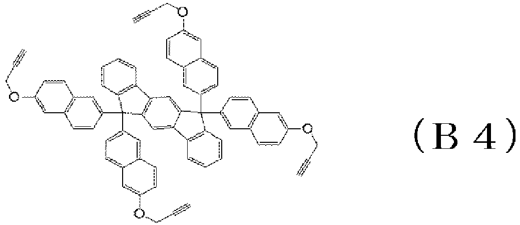

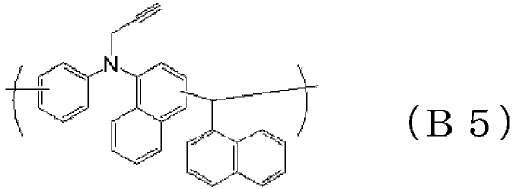

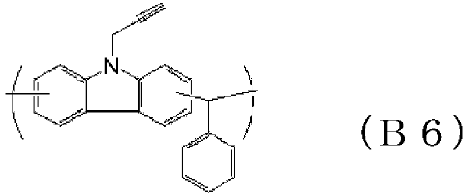

### [Solvents]

(C1): propylene glycol monomethyl ether acetate
(C2): propylene glycol monoethyl ether

### [Preparation of Compositions (UDL-1 to -59 and Comparative UDL-1 to -11) for Forming Organic Film]

The polymers (A1) to (A8), comparative polymers (R1) to (R5), resins (B1) to (B6) for forming an organic film, and solvents (C1) to (C2) were dissolved in the proportions shown in Tables 4 to 6. Then, the solutions were filtered through a 0.1-pm filter made of a fluorinated resin to prepare compositions (resist underlayer film materials: UDL-1 to -59 and comparative UDL-1 to -11) for forming an organic film.

**[Table 4]**

| Composition for forming organic film | Resin for forming organic film | | Polymer | | Solvent 1 | | Solvent 2 | |
|---|---|---|---|---|---|---|---|---|
| | Type | Parts by mass | Type | Parts by mass | Type | Parts by mass | Type | Parts by mass |
| UDL-1 | (B1) | 10.00 | (A1) | 0.10 | (C1) | 89.90 | | |
| UDL-2 | (B1) | 10.00 | (A2) | 0.10 | (C1) | 89.90 | | |
| UDL-3 | (B1) | 10.00 | (A3) | 0.10 | (C1) | 89.90 | | |
| UDL-4 | (B1) | 10.00 | (A4) | 0.10 | (C1) | 89.90 | | |
| UDL-5 | (B1) | 10.00 | (A5) | 0.10 | (C1) | 89.90 | | |
| UDL-6 | (B1) | 10.00 | (A6) | 0.10 | (C1) | 89.90 | | |
| UDL-7 | (B1) | 10.00 | (A7) | 0.10 | (C1) | 89.90 | | |
| UDL-8 | (B1) | 10.00 | (A8) | 0.10 | (C1) | 89.90 | | |
| UDL-9 | (B1) | 10.00 | (A1) | 0.10 | (C1) | 62.93 | (C2) | 26.97 |
| UDL-10 | (B1) | 10.00 | (A2) | 0.10 | (C1) | 62.93 | (C2) | 26.97 |
| UDL-11 | (B1) | 10.00 | (A3) | 0.10 | (C1) | 62.93 | (C2) | 26.97 |
| UDL-12 | (B1) | 10.00 | (A4) | 0.10 | (C1) | 62.93 | (C2) | 26.97 |
| UDL-13 | (B1) | 10.00 | (A5) | 0.10 | (C1) | 62.93 | (C2) | 26.97 |
| UDL-14 | (B1) | 10.00 | (A6) | 0.10 | (C1) | 62.93 | (C2) | 26.97 |
| UDL-15 | (B1) | 10.00 | (A7) | 0.10 | (C1) | 62.93 | (C2) | 26.97 |
| UDL-16 | (B1) | 10.00 | (A8) | 0.10 | (C1) | 62.93 | (C2) | 26.97 |
| UDL-17 | (B1) | 10.00 | (A1) | 1.00 | (C1) | 89.00 | | |
| UDL-18 | (B1) | 10.00 | (A1) | 0.50 | (C1) | 89.50 | | |
| UDL-19 | (B1) | 10.000 | (A1) | 0.001 | (C1) | 89.999 | | |
| UDL-20 | (B2) | 10.00 | (A1) | 0.10 | (C1) | 89.90 | | |
| UDL-21 | (B2) | 10.00 | (A2) | 0.10 | (C1) | 89.90 | | |
| UDL-22 | (B2) | 10.00 | (A3) | 0.10 | (C1) | 89.90 | | |
| UDL-23 | (B2) | 10.00 | (A4) | 0.10 | (C1) | 89.90 | | |
| UDL-24 | (B2) | 10.00 | (A5) | 0.10 | (C1) | 89.90 | | |
| UDL-25 | (B2) | 10.00 | (A6) | 0.10 | (C1) | 89.90 | | |
| UDL-26 | (B2) | 10.00 | (A7) | 0.10 | (C1) | 89.90 | | |
| UDL-27 | (B2) | 10.00 | (A8) | 0.10 | (C1) | 89.90 | | |
| UDL-28 | (B3) | 10.00 | (A1) | 0.10 | (C1) | 89.90 | | |
| UDL-29 | (B3) | 10.00 | (A2) | 0.10 | (C1) | 89.90 | | |
| UDL-30 | (B3) | 10.00 | (A3) | 0.10 | (C1) | 89.90 | | |
| UDL-31 | (B3) | 10.00 | (A4) | 0.10 | (C1) | 89.90 | | |

**[Table 5]**

| Composition for forming organic film | Resin for forming organic film | | Polymer | | Solvent 1 | | Solvent 2 | |
|---|---|---|---|---|---|---|---|---|
| | Type | Parts by mass | Type | Parts by mass | Type | Parts by mass | Type | Parts by mass |
| UDL-32 | (B3) | 10.00 | (A5) | 0.10 | (C1) | 89.90 | | |
| UDL-33 | (B3) | 10.00 | (A6) | 0.10 | (C1) | 89.90 | | |
| UDL-34 | (B3) | 10.00 | (A7) | 0.10 | (C1) | 89.90 | | |
| UDL-35 | (B3) | 10.00 | (A8) | 0.10 | (C1) | 89.90 | | |
| UDL-36 | (B4) | 10.00 | (A1) | 0.10 | (C1) | 89.90 | | |
| UDL-37 | (B4) | 10.00 | (A2) | 0.10 | (C1) | 89.90 | | |
| UDL-38 | (B4) | 10.00 | (A3) | 0.10 | (C1) | 89.90 | | |
| UDL-39 | (B4) | 10.00 | (A4) | 0.10 | (C1) | 89.90 | | |
| UDL-40 | (B4) | 10.00 | (A5) | 0.10 | (C1) | 89.90 | | |
| UDL-41 | (B4) | 10.00 | (A6) | 0.10 | (C1) | 89.90 | | |
| UDL-42 | (B4) | 10.00 | (A7) | 0.10 | (C1) | 89.90 | | |
| UDL-43 | (B4) | 10.00 | (A8) | 0.10 | (C1) | 89.90 | | |
| UDL-44 | (B5) | 10.00 | (A1) | 0.10 | (C1) | 89.90 | | |
| UDL-45 | (B5) | 10.00 | (A2) | 0.10 | (C1) | 89.90 | | |
| UDL-46 | (B5) | 10.00 | (A3) | 0.10 | (C1) | 89.90 | | |
| UDL-47 | (B5) | 10.00 | (A4) | 0.10 | (C1) | 89.90 | | |
| UDL-48 | (B5) | 10.00 | (A5) | 0.10 | (C1) | 89.90 | | |
| UDL-49 | (B5) | 10.00 | (A6) | 0.10 | (C1) | 89.90 | | |
| UDL-50 | (B5) | 10.00 | (A7) | 0.10 | (C1) | 89.90 | | |
| UDL-51 | (B5) | 10.00 | (A8) | 0.10 | (C1) | 89.90 | | |
| UDL-52 | (B6) | 10.00 | (A1) | 0.10 | (C1) | 89.90 | | |
| UDL-53 | (B6) | 10.00 | (A2) | 0.10 | (C1) | 89.90 | | |
| UDL-54 | (B6) | 10.00 | (A3) | 0.10 | (C1) | 89.90 | | |
| UDL-55 | (B6) | 10.00 | (A4) | 0.10 | (C1) | 89.90 | | |
| UDL-56 | (B6) | 10.00 | (A5) | 0.10 | (C1) | 89.90 | | |
| UDL-57 | (B6) | 10.00 | (A6) | 0.10 | (C1) | 89.90 | | |
| UDL-58 | (B6) | 10.00 | (A7) | 0.10 | (C1) | 89.90 | | |
| UDL-59 | (B6) | 10.00 | (A8) | 0.10 | (C1) | 89.90 | | |

**[Table 6]**

| Composition for forming organic film | Resin for forming organic film | | Polymer | | Solvent 1 | | Solvent 2 | |
|---|---|---|---|---|---|---|---|---|
| | Type | Parts by mass | Type | Parts by mass | Type | Parts by mass | Type | Parts by mass |
| Comparative UDL-1 | (B1) | 10.00 | (R1) | 0.10 | (C1) | 89.90 | | |
| Comparative UDL-2 | (B2) | 10.00 | (R2) | 0.10 | (C1) | 89.90 | | |
| Comparative UDL-3 | (B3) | 10.00 | (R3) | 0.10 | (C1) | 89.90 | | |
| Comparative UDL-4 | (B4) | 10.00 | (R4) | 0.10 | (C1) | 89.90 | | |
| Comparative UDL-5 | (B5) | 10.00 | (R5) | 0.10 | (C1) | 89.90 | | |
| Comparative UDL-6 | (B1) | 10.00 | | | (C1) | 90.00 | | |
| Comparative UDL-7 | (B2) | 10.00 | | | (C1) | 90.00 | | |
| Comparative UDL-8 | (B3) | 10.00 | | | (C1) | 90.00 | | |
| Comparative UDL-9 | (B4) | 10.00 | | | (C1) | 90.00 | | |
| Comparative UDL-10 | (B5) | 10.00 | | | (C1) | 90.00 | | |
| Comparative UDL-11 | (B6) | 10.00 | | | (C1) | 90.00 | | |

### [Preparation of Silicon Wafers Having Organic Film Formed Thereon By Using Compositions (UDL-1 to -59 and Comparative UDL-1 to -11) for Forming Organic Film]

Using a coater/developer "CLEAN TRACK LITHIUS Pro AP" of Tokyo Electron Ltd., each of the compositions (UDL-1 to -59 and comparative UDL-1 to -11) for forming an organic film prepared above was respectively discharged in an amount of 2 ml onto a silicon wafer at the center and baked. Then, the wafer was rotated at a rotational rate to achieve the average film thickness shown in Tables 7 to 9 to spread the composition, and thus, a film was formed. While rotating the silicon wafer at a rate of 1,000 rpm, the remover-discharging nozzle was moved at a speed of 5 mm/s from the periphery of the silicon wafer to a position 3 mm from the center while discharging a remover (mixed solution of propylene glycol monomethyl ether acetate and propylene glycol monomethyl ether (30:70, mass ratio)) at a discharge rate of 2 ml/s, and the remover was further discharged at that position for 5 seconds at a discharge rate of 2 ml/s. After that, the discharging of the discharged liquid was terminated, and the wafer was further rotated at a rate of 1,000 rpm for 30 seconds. Next, the silicon wafer, having a film of the composition for forming an organic film formed thereon, was heated at 350°C for 60 seconds for curing. Thus, silicon wafers having an organic film formed were obtained.

### [Solvent Resistance Evaluation: Examples 1-1 to 1-59 and Comparative Examples 1-1 to 1-11]

A film of each of the compositions (UDL-1 to -59 and comparative UDL-1 to -11) for forming an organic film was respectively formed on a silicon wafer by the above-described method, and the film thickness was measured. A PGMEA solvent was dispensed thereon, the wafer left to stand for 30 seconds, spin-dried, and baked at 100°C for 60 seconds to evaporate the PGMEA, and the film thickness was measured. The absolute value of the value determined by [(X₁-X)/X]×100 was obtained as a film thickness change rate (%), where X is the film thickness before dispensing the PGMEA solvent, and X₁ is the film thickness after the PGMEA solvent was dispensed. When the film thickness change rate was lower than 0.5%, the composition was evaluated as "Good", and when 0.5% or higher, "Poor". Tables 7 to 9 show the results.

### [In-Plane Uniformity Evaluation: Examples 1-1 to 1-59 and Comparative Examples 1-1 to 1-11]

A film of each of the compositions (UDL-1 to -59 and comparative UDL-1 to -11) for forming an organic film was respectively formed on a silicon wafer by the above-described method, and the film thickness of the organic film within a radius of 145 mm from the center was measured. The value determined by (Xₘₐₓ-Xₘᵢₙ)/X_{average} was obtained as in-plane uniformity (%), where Xₘₐₓ is the maximum value of the film thickness, Xₘᵢₙ is the minimum value of the film thickness, and X_{average} is the average film thickness. When the in-plane uniformity was less than 2%, the composition was evaluated as A (very good), when 2% or more to less than 3%, B (good), and when 3% or more, C (poor). Tables 7 to 9 show the results.

**[Table 7]**

| | Composition for forming organic film | Average film thickness | Solvent resistance | In-plane uniformity |
|---|---|---|---|---|
| Example 1-1 | UDL-1 | 500 nm | Good | A |
| Example 1-2 | UDL-2 | 500 nm | Good | A |
| Example 1-3 | UDL-3 | 500 nm | Good | A |
| Example 1-4 | UDL-4 | 500 nm | Good | A |
| Example 1-5 | UDL-5 | 500 nm | Good | A |
| Example 1-6 | UDL-6 | 500 nm | Good | A |
| Example 1-7 | UDL-7 | 500 nm | Good | A |
| Example 1-8 | UDL-8 | 500 nm | Good | A |
| Example 1-9 | UDL-9 | 500 nm | Good | A |
| Example 1-10 | UDL-10 | 500 nm | Good | A |
| Example 1-11 | UDL-11 | 500 nm | Good | A |
| Example 1-12 | UDL-12 | 500 nm | Good | A |
| Example 1-13 | UDL-13 | 500 nm | Good | A |
| Example 1-14 | UDL-14 | 500 nm | Good | A |
| Example 1-15 | UDL-15 | 500 nm | Good | A |
| Example 1-16 | UDL-16 | 500 nm | Good | A |
| Example 1-17 | UDL-17 | 500 nm | Good | B |
| Example 1-18 | UDL-18 | 500 nm | Good | A |
| Example 1-19 | UDL-19 | 500 nm | Good | B |
| Example 1-20 | UDL-20 | 500 nm | Good | A |
| Example 1-21 | UDL-21 | 500 nm | Good | A |
| Example 1-22 | UDL-22 | 500 nm | Good | A |
| Example 1-23 | UDL-23 | 500 nm | Good | A |
| Example 1-24 | UDL-24 | 500 nm | Good | A |
| Example 1-25 | UDL-25 | 500 nm | Good | A |
| Example 1-26 | UDL-26 | 500 nm | Good | A |
| Example 1-27 | UDL-27 | 500 nm | Good | A |
| Example 1-28 | UDL-28 | 500 nm | Good | A |
| Example 1-29 | UDL-29 | 500 nm | Good | A |
| Example 1-30 | UDL-30 | 500 nm | Good | A |
| Example 1-31 | UDL-31 | 500 nm | Good | A |

**[Table 8]**

| | Composition for forming organic film | Average film thickness | Solvent resistance | In-plane uniformity |
|---|---|---|---|---|
| Example 1-32 | UDL-32 | 500 nm | Good | A |
| Example 1-33 | UDL-33 | 500 nm | Good | A |
| Example 1-34 | UDL-34 | 500 nm | Good | A |
| Example 1-35 | UDL-35 | 500 nm | Good | A |
| Example 1-36 | UDL-36 | 500 nm | Good | A |
| Example 1-37 | UDL-37 | 500 nm | Good | A |
| Example 1-38 | UDL-38 | 500 nm | Good | A |
| Example 1-39 | UDL-39 | 500 nm | Good | A |
| Example 1-40 | UDL-40 | 500 nm | Good | A |
| Example 1-41 | UDL-41 | 500 nm | Good | A |
| Example 1-42 | UDL-42 | 500 nm | Good | A |
| Example 1-43 | UDL-43 | 500 nm | Good | A |
| Example 1-44 | UDL-44 | 500 nm | Good | A |
| Example 1-45 | UDL-45 | 500 nm | Good | A |
| Example 1-46 | UDL-46 | 500 nm | Good | A |
| Example 1-47 | UDL-47 | 500 nm | Good | A |
| Example 1-48 | UDL-48 | 500 nm | Good | A |
| Example 1-49 | UDL-49 | 500 nm | Good | A |
| Example 1-50 | UDL-50 | 500 nm | Good | A |
| Example 1-51 | UDL-51 | 500 nm | Good | A |
| Example 1-52 | UDL-52 | 500 nm | Good | A |
| Example 1-53 | UDL-53 | 500 nm | Good | A |
| Example 1-54 | UDL-54 | 500 nm | Good | A |
| Example 1-55 | UDL-55 | 500 nm | Good | A |
| Example 1-56 | UDL-56 | 500 nm | Good | A |
| Example 1-57 | UDL-57 | 500 nm | Good | A |
| Example 1-58 | UDL-58 | 500 nm | Good | A |
| Example 1-59 | UDL-59 | 500 nm | Good | A |

**[Table 9]**

| | Composition for forming organic film | Average film thickness | Solvent resistance | In-plane uniformity |
|---|---|---|---|---|
| Comparative Example 1-1 | Comparative UDL-1 | 500 nm | Good | A |
| Comparative Example 1-2 | Comparative UDL-2 | 500 nm | Good | A |
| Comparative Example 1-3 | Comparative UDL-3 | 500 nm | Good | A |
| Comparative Example 1-4 | Comparative UDL-4 | 500 nm | Good | A |
| Comparative Example 1-5 | Comparative UDL-5 | 500 nm | Good | A |
| Comparative Example 1-6 | Comparative UDL-6 | 500 nm | Good | C |
| Comparative Example 1-7 | Comparative UDL-7 | 500 nm | Good | C |
| Comparative Example 1-8 | Comparative UDL-8 | 500 nm | Good | C |
| Comparative Example 1-9 | Comparative UDL-9 | 500 nm | Good | C |
| Comparative Example 1-10 | Comparative UDL-10 | 500 nm | Good | C |
| Comparative Example 1-11 | Comparative UDL-11 | 500 nm | Good | C |

### [Hump Suppression Property Evaluation: Examples 2-1 to 2-59 and Comparative Examples 2-1 to 2-5]

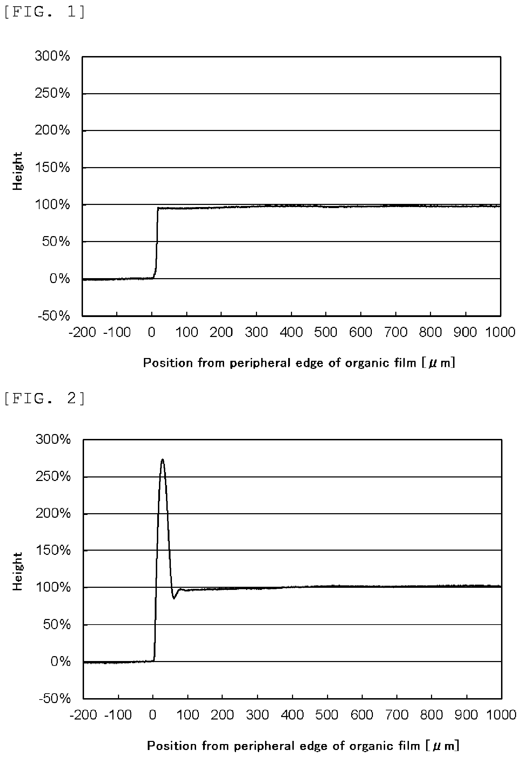

A film of each of the compositions (UDL-1 to -59 and comparative UDL-1 to -5) for forming an organic film was respectively formed on a silicon wafer by the above-described method, and the change in height was measured by using Alpha-Step D-600 (a stylus profiler) manufactured by KLA corporation from the peripheral edge of the organic film towards the center of the silicon wafer to a position of 1,000 um. The height of the silicon wafer was set to 0, and when the maximum height was less than 110% of the film thickness as shown in FIG. 1, the composition was evaluated as A (very good), when the maximum height was 110% or more to less than 150%, B (good), and when a region where the height was 150% or more occurred as shown in FIG. 2, C (poor). Tables 10 to 12 show the results.

### [Filling Property Evaluation: Examples 2-1 to 2-59 and Comparative Examples 2-1 to 2-5]

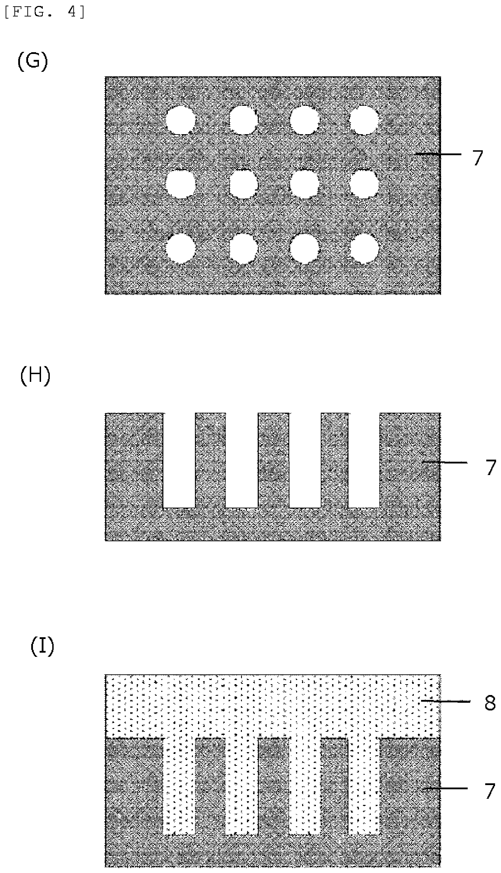

As shown in FIG. 4, a film of each of the compositions (UDL-1 to -59 and comparative UDL-1 to -5) for forming an organic film was respectively formed by the above-described method on an SiO₂ wafer substrate having a dense hole pattern (hole diameter 0.2 um, hole depth 1.0 um, distance between the centers of two adjacent holes 0.4 um). Thus, an organic film 8 was formed. The substrate used was a base substrate (SiO₂ wafer substrate) 7 having a dense hole pattern shown in FIG. 4(G) (downward view) and (H) (cross-sectional view). The cross-sectional shape of each of the obtained wafer substrates was observed using a scanning electron microscope (SEM), and it was observed whether or not the inside of the holes was filled with the organic film without gaps. When a composition for forming an organic film having poor filling property is used, gaps are generated inside the holes. When a composition for forming an organic film having a desirable filling property is used in the present evaluation, the inside of the holes is filled with the organic film 8 without gaps, as shown in FIG. 4(I). The composition was evaluated as "Good" when no gaps were generated, and when gaps were generated, as "Poor". Tables 10 to 12 show the results.

**[Table 10]**

| | Composition for forming organic film | Hump suppression property evaluation | Filling property evaluation |
|---|---|---|---|
| Example 2-1 | UDL-1 | A | Good |
| Example 2-2 | UDL-2 | B | Good |
| Example 2-3 | UDL-3 | B | Good |
| Example 2-4 | UDL-4 | B | Good |
| Example 2-5 | UDL-5 | A | Good |
| Example 2-6 | UDL-6 | B | Good |
| Example 2-7 | UDL-7 | A | Good |
| Example 2-8 | UDL-8 | A | Good |
| Example 2-9 | UDL-9 | A | Good |
| Example 2-10 | UDL-10 | B | Good |
| Example 2-11 | UDL-11 | B | Good |
| Example 2-12 | UDL-12 | B | Good |
| Example 2-13 | UDL-13 | A | Good |
| Example 2-14 | UDL-14 | B | Good |
| Example 2-15 | UDL-15 | A | Good |
| Example 2-16 | UDL-16 | A | Good |
| Example 2-17 | UDL-17 | A | Good |
| Example 2-18 | UDL-18 | A | Good |
| Example 2-19 | UDL-19 | A | Good |
| Example 2-20 | UDL-20 | A | Good |
| Example 2-21 | UDL-21 | B | Good |
| Example 2-22 | UDL-22 | B | Good |
| Example 2-23 | UDL-23 | B | Good |
| Example 2-24 | UDL-24 | A | Good |
| Example 2-25 | UDL-25 | B | Good |
| Example 2-26 | UDL-26 | A | Good |
| Example 2-27 | UDL-27 | A | Good |
| Example 2-28 | UDL-28 | A | Good |
| Example 2-29 | UDL-29 | B | Good |
| Example 2-30 | UDL-30 | B | Good |
| Example 2-31 | UDL-31 | B | Good |

**[Table 11]**

| | Composition for forming organic film | Hump suppression property evaluation | Filling property evaluation |
|---|---|---|---|
| Example 2-32 | UDL-32 | A | Good |
| Example 2-33 | UDL-33 | B | Good |
| Example 2-34 | UDL-34 | A | Good |
| Example 2-35 | UDL-35 | A | Good |
| Example 2-36 | UDL-36 | A | Good |
| Example 2-37 | UDL-37 | B | Good |
| Example 2-38 | UDL-38 | B | Good |
| Example 2-39 | UDL-39 | B | Good |
| Example 2-40 | UDL-40 | A | Good |
| Example 2-41 | UDL-41 | B | Good |
| Example 2-42 | UDL-42 | A | Good |
| Example 2-43 | UDL-43 | A | Good |
| Example 2-44 | UDL-44 | A | Good |
| Example 2-45 | UDL-45 | B | Good |
| Example 2-46 | UDL-46 | B | Good |
| Example 2-47 | UDL-47 | B | Good |
| Example 2-48 | UDL-48 | A | Good |
| Example 2-49 | UDL-49 | B | Good |
| Example 2-50 | UDL-50 | A | Good |
| Example 2-51 | UDL-51 | A | Good |
| Example 2-52 | UDL-52 | A | Good |
| Example 2-53 | UDL-53 | B | Good |
| Example 2-54 | UDL-54 | B | Good |
| Example 2-55 | UDL-55 | B | Good |
| Example 2-56 | UDL-56 | A | Good |
| Example 2-57 | UDL-57 | B | Good |
| Example 2-58 | UDL-58 | A | Good |
| Example 2-59 | UDL-59 | A | Good |

**[Table 12]**

| | Composition for forming organic film | Hump suppression property evaluation | Filling property evaluation |
|---|---|---|---|
| Comparative Example 2-1 | Comparative UDL-1 | C | Poor |
| Comparative Example 2-2 | Comparative UDL-2 | C | Poor |
| Comparative Example 2-3 | Comparative UDL-3 | C | Poor |
| Comparative Example 2-4 | Comparative UDL-4 | C | Poor |
| Comparative Example 2-5 | Comparative UDL-5 | A | Poor |

As shown in Tables 7 to 12, it was confirmed that the inventive compositions (UDL-1 to -59) for forming an organic film were excellent in solvent resistance, in-plane uniformity, hump suppression property, and filling property.

On the other hand, it was confirmed that comparative UDL-1 to -11, not containing the inventive composition for forming an organic film, had a poor result in one or more of solvent resistance, in-plane uniformity, hump suppression property, and filling property.

### [Patterning Test: Examples 3-1 to 3-59]

An organic film was formed respectively on a SiO₂ wafer substrate by using each of the compositions (UDL-1 to -59) for forming an organic film by the above-described method, the silicon-containing resist middle layer film material (SOG1) described below was applied thereto, and baking was performed at 200°C for 60 seconds to form a 35-nm thick silicon-containing resist middle layer film. The monolayer resist for ArF described below was applied thereto as a resist upper layer film material and baked at 105°C for 60 seconds to form a 100-nm thick photoresist film. The liquid immersion top coat composition (TC-1) described below was applied to the photoresist film and baked at 90°C for 60 seconds to form a 50-nm thick top coat.

As the silicon-containing resist middle layer film material (SOG1), a 2% solution of the following polymer in propylene glycol ethyl ether was prepared.

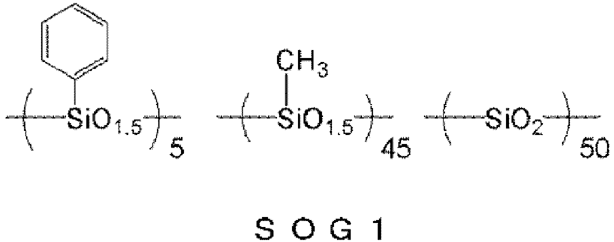

The resist upper layer film material (monolayer resist for ArF) was prepared by dissolving a polymer (RP1), an acid generator (PAG1), and a basic compound (Amine1), each in the proportion shown in Table 13, in a solvent containing 0.1% by mass of FC-430 (manufactured by Sumitomo 3M Limited), and filtering the solution through a 0.1-pm filter made of a fluororesin.

**[Table 13]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2, 500) |

The polymer (RP1), the acid generator (PAG1), and the basic compound (Amine1) are shown below.

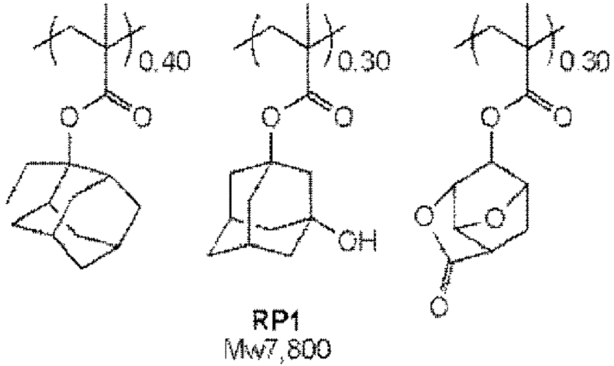

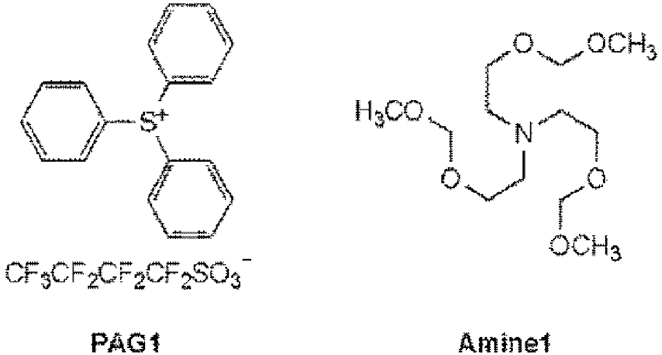

The liquid immersion top coat composition (TC-1) was prepared by dissolving a polymer (PP1) in an organic solvent at the proportion shown in Table 14, and filtering the solution through a 0.1-pm filter made of a fluororesin.

**[Table 14]**

| | Polymer (parts by mass) | Organic solvent (parts by mass) |
|---|---|---|
| TC-1 | PP1 (100) | Diisoamyl ether (2,700) 2-methyl-1-butanol (270) |

The polymer (PP1) is shown below.

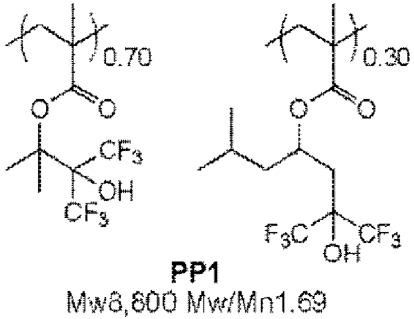

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 55 nm 1:1 positive line-and-space pattern (a resist upper layer film pattern).

Subsequently, the silicon-containing resist middle layer film was dry-etched (the pattern was transferred) by using an etching apparatus Telius manufactured by Tokyo Electron Ltd. while using the resist upper layer film pattern as a mask; the organic film was dry-etched (the pattern was transferred) while using the obtained silicon-containing resist middle layer film pattern as a mask; and the SiO₂ wafer substrate (SiO₂ film) was dry-etched (the pattern was transferred) while using the obtained organic film pattern as a mask. The etching conditions were as follows.

Conditions in transferring resist upper layer film pattern to silicon-containing resist middle layer film
Chamber pressure: 10.0 Pa
RF-power: 1,500 W
CF₄ gas flow rate: 75 mL/min
O₂ gas flow rate: 15 mL/min
Time: 15 sec

Conditions in transferring silicon-containing resist middle layer film pattern to organic film
Chamber pressure: 2.0 Pa
RF-power: 500 W
Ar gas flow rate: 75 mL/min
O₂ gas flow rate: 45 mL/min
Time: 120 sec

Conditions in transferring organic film pattern to SiO₂ wafer substrate
Chamber pressure: 2.0 Pa
RF-power: 2,200 W
C₅F₁₂ gas flow rate: 20 mL/min
C₂F₆ gas flow rate: 10 mL/min
Ar gas flow rate: 300 mL/min
O₂ gas flow rate: 60 mL/min
Time: 90 sec

The cross section of the obtained pattern was observed with an electron microscope (S-4700) manufactured by Hitachi, Ltd. Tables 15 and 16 show the results.

**[Table 15]**

| | Composition for forming organic film | Profile after etching for transferring to substrate |
|---|---|---|
| Example 3-1 | UDL-1 | Good |
| Example 3-2 | UDL-2 | Good |
| Example 3-3 | UDL-3 | Good |
| Example 3-4 | UDL-4 | Good |
| Example 3-5 | UDL-5 | Good |
| Example 3-6 | UDL-6 | Good |
| Example 3-7 | UDL-7 | Good |
| Example 3-8 | UDL-8 | Good |
| Example 3-9 | UDL-9 | Good |
| Example 3-10 | UDL-10 | Good |
| Example 3-11 | UDL-11 | Good |
| Example 3-12 | UDL-12 | Good |
| Example 3-13 | UDL-13 | Good |
| Example 3-14 | UDL-14 | Good |
| Example 3-15 | UDL-15 | Good |
| Example 3-16 | UDL-16 | Good |
| Example 3-17 | UDL-17 | Good |
| Example 3-18 | UDL-18 | Good |
| Example 3-19 | UDL-19 | Good |
| Example 3-20 | UDL-20 | Good |
| Example 3-21 | UDL-21 | Good |
| Example 3-22 | UDL-22 | Good |
| Example 3-23 | UDL-23 | Good |
| Example 3-24 | UDL-24 | Good |
| Example 3-25 | UDL-25 | Good |
| Example 3-26 | UDL-26 | Good |
| Example 3-27 | UDL-27 | Good |
| Example 3-28 | UDL-28 | Good |
| Example 3-29 | UDL-29 | Good |
| Example 3-30 | UDL-30 | Good |
| Example 3-31 | UDL-31 | Good |

**[Table 16]**

| | Composition for forming organic film | Profile after etching for transferring to substrate |
|---|---|---|
| Example 3-32 | UDL-32 | Good |
| Example 3-33 | UDL-33 | Good |
| Example 3-34 | UDL-34 | Good |
| Example 3-35 | UDL-35 | Good |
| Example 3-36 | UDL-36 | Good |
| Example 3-37 | UDL-37 | Good |
| Example 3-38 | UDL-38 | Good |
| Example 3-39 | UDL-39 | Good |
| Example 3-40 | UDL-40 | Good |
| Example 3-41 | UDL-41 | Good |
| Example 3-42 | UDL-42 | Good |
| Example 3-43 | UDL-43 | Good |
| Example 3-44 | UDL-44 | Good |
| Example 3-45 | UDL-45 | Good |
| Example 3-46 | UDL-46 | Good |
| Example 3-47 | UDL-47 | Good |
| Example 3-48 | UDL-48 | Good |
| Example 3-49 | UDL-49 | Good |
| Example 3-50 | UDL-50 | Good |
| Example 3-51 | UDL-51 | Good |
| Example 3-52 | UDL-52 | Good |
| Example 3-53 | UDL-53 | Good |
| Example 3-54 | UDL-54 | Good |
| Example 3-55 | UDL-55 | Good |
| Example 3-56 | UDL-56 | Good |
| Example 3-57 | UDL-57 | Good |
| Example 3-58 | UDL-58 | Good |
| Example 3-59 | UDL-59 | Good |

As shown in Tables 15 and 16, in Examples 3-1 to 3-59, where the inventive compositions (UDL-1 to -59) for forming an organic film were used, the resist upper layer film pattern was successfully transferred to the SiO₂ wafer substrate in the end in every case. Thus, it was confirmed that the inventive composition for forming an organic film can be used suitably for fine processing using a multilayer resist method.

From the above, the inventive composition for forming an organic film has excellent film-formability and high filling property and hump suppression property, and therefore, is extremely useful as an organic film material used in a multilayer resist process. Furthermore, the inventive patterning processes, using the composition, makes it possible to fill holes and trenches having very high aspect ratios without gaps, form a fine pattern with high precision, and form a hump-suppressed organic film, and therefore, makes it possible to manufacture semiconductor devices and the like efficiently.

The present description includes the following embodiments.
[1]: A composition for forming an organic film, comprising: (A) a polymer having a repeating unit represented by the following general formula (1); (B) a resin for forming an organic film; and (C) a solvent, 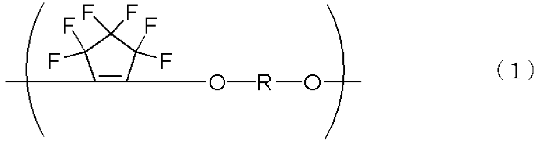 wherein R represents a saturated or unsaturated divalent organic group having 2 to 30 carbon atoms.
[2]: The composition for forming an organic film of the above [1], wherein the polymer (A) has any one or more of the following general formulae (2) to (4), 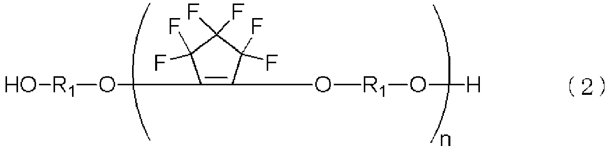 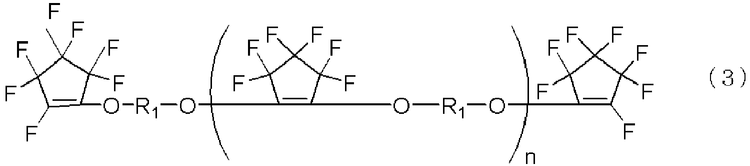 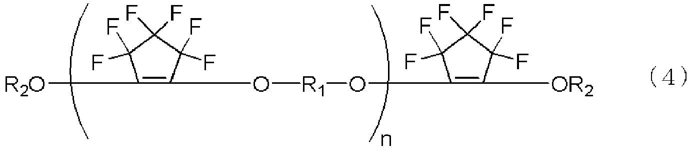 wherein R₁ represents a saturated or unsaturated divalent hydrocarbon group having 4 to 10 carbon atoms and optionally having an ether bond; R₂ represents a monovalent organic group having 1 to 30 carbon atoms; and "n" represents an average repeating unit number of 3 to 2,000.
[3]: The composition for forming an organic film of the above [1] or [2], wherein the polymer (A) is contained in an amount of 0.01 parts by mass to 5 parts by mass based on 100 parts by mass of the resin (B) for forming an organic film.
[4]: A method for forming an organic film to be used in a manufacturing process of a semiconductor device, the method comprising: spin-coating a substrate to be processed with the composition for forming an organic film of any one of the above [1] to [3]; and forming an organic film by heating the substrate coated with the composition for forming an organic film at a temperature of 100°C or higher and 600°C or lower for 10 to 600 seconds to cure the composition.
[5]: A patterning process comprising:
   forming an organic film on a body to be processed by using the composition for forming an organic film of any one of the above [1] to [3];
   forming a silicon-containing resist middle layer film on the organic film by using a silicon-containing resist middle layer film material;
   forming a resist upper layer film on the silicon-containing resist middle layer film by using a resist upper layer film material comprising a photoresist composition;
   forming a circuit pattern in the resist upper layer film;
   transferring the pattern to the silicon-containing resist middle layer film by etching while using the resist upper layer film having the formed circuit pattern as a mask;
   transferring the pattern to the organic film by etching while using the silicon-containing resist middle layer film having the transferred pattern as a mask; and
   further transferring the pattern to the body to be processed by etching while using the organic film having the transferred pattern as a mask.
[6]: A patterning process comprising:
   forming an organic film on a body to be processed by using the composition for forming an organic film of any one of the above [1] to [3];
   forming a silicon-containing resist middle layer film on the organic film by using a silicon-containing resist middle layer film material;
   forming an organic antireflective film or an adhesive film on the silicon-containing resist middle layer film;
   forming a resist upper layer film on the organic antireflective film or the adhesive film by using a resist upper layer film material comprising a photoresist composition;
   forming a circuit pattern in the resist upper layer film;
   transferring the pattern to the organic antireflective film or the adhesive film and the silicon-containing resist middle layer film by etching while using the resist upper layer film having the formed circuit pattern as a mask;
   transferring the pattern to the organic film by etching while using the silicon-containing resist middle layer film having the transferred pattern as a mask; and
   further transferring the pattern to the body to be processed by etching while using the organic film having the transferred pattern as a mask.
[7]: A patterning process comprising:
   forming an organic film on a body to be processed by using the composition for forming an organic film of any one of the above [1] to [3];
   forming an inorganic hard mask middle layer film selected from a silicon oxide film, a silicon nitride film, and a silicon oxynitride film on the organic film;
   forming a resist upper layer film on the inorganic hard mask middle layer film by using a resist upper layer film material comprising a photoresist composition;
   forming a circuit pattern in the resist upper layer film;
   transferring the pattern to the inorganic hard mask middle layer film by etching while using the resist upper layer film having the formed circuit pattern as a mask;
   transferring the pattern to the organic film by etching while using the inorganic hard mask middle layer film having the transferred pattern as a mask; and
   further transferring the pattern to the body to be processed by etching while using the organic film having the transferred pattern as a mask.
[8]: A patterning process comprising:
   forming an organic film on a body to be processed by using the composition for forming an organic film of any one of the above [1] to [3];
   forming an inorganic hard mask middle layer film selected from a silicon oxide film, a silicon nitride film, and a silicon oxynitride film on the organic film;
   forming an organic antireflective film or an adhesive film on the inorganic hard mask middle layer film;
   forming a resist upper layer film on the organic antireflective film or the adhesive film by using a resist upper layer film material comprising a photoresist composition;
   forming a circuit pattern in the resist upper layer film;
   transferring the pattern to the organic antireflective film or the adhesive film and the inorganic hard mask middle layer film by etching while using the resist upper layer film having the formed circuit pattern as a mask;
   transferring the pattern to the organic film by etching while using the inorganic hard mask middle layer film having the transferred pattern as a mask; and
   further transferring the pattern to the body to be processed by etching while using the organic film having the transferred pattern as a mask.
[9]: The patterning process of the above [7] or [8], wherein the inorganic hard mask middle layer film is formed by a CVD method or an ALD method.
[10]: The patterning process of any one of the above [5] to [9], wherein the circuit pattern is formed by a lithography using light having a wavelength of 10 nm or more and 300 nm or less, a direct writing with electron beam, nanoimprinting, or a combination thereof.
[11]: The patterning process of any one of the above [5] to [10], wherein the circuit pattern is developed with an alkaline development or an organic solvent.
[12]: The patterning process of any one of the above [5] to [11], wherein the body to be processed is a semiconductor device substrate or the semiconductor device substrate coated with any of a metal film, a metal carbide film, a metal oxide film, a metal nitride film, a metal oxycarbide film, and a metal oxynitride film.
[13]: The patterning process of the above [12], wherein the metal constituting the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A composition for forming an organic film, comprising: (A) a polymer having a repeating unit represented by the following general formula (1); (B) a resin for forming an organic film; and (C) a solvent, 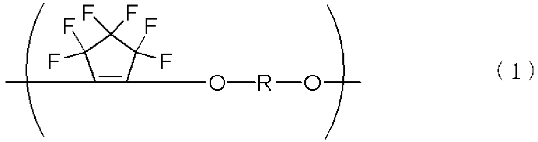 wherein R represents a saturated or unsaturated divalent organic group having 2 to 30 carbon atoms.

2. The composition for forming an organic film according to claim 1, wherein the polymer (A) has any one or more of the following general formulae (2) to (4), 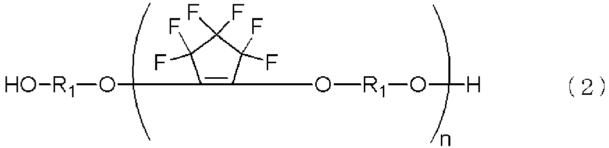 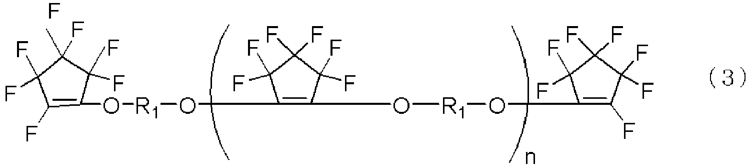 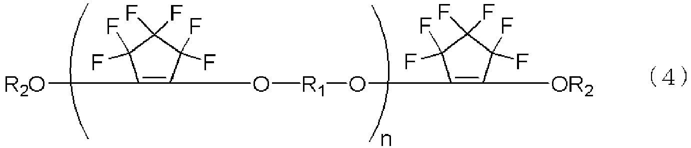 wherein R₁ represents a saturated or unsaturated divalent hydrocarbon group having 4 to 10 carbon atoms and optionally having an ether bond; R₂ represents a monovalent organic group having 1 to 30 carbon atoms; and "n" represents an average repeating unit number of 3 to 2, 000.

3. The composition for forming an organic film according to claim 1 or 2, wherein the polymer (A) is contained in an amount of 0.01 parts by mass to 5 parts by mass based on 100 parts by mass of the resin (B) for forming an organic film.

4. A method for forming an organic film to be used in a manufacturing process of a semiconductor device, the method comprising: spin-coating a substrate to be processed with the composition for forming an organic film according to any one of claims 1 to 3; and forming an organic film by heating the substrate coated with the composition for forming an organic film at a temperature of 100°C or higher and 600°C or lower for 10 to 600 seconds to cure the composition.

5. A patterning process comprising:
forming an organic film on a body to be processed by using the composition for forming an organic film according to any one of claims 1 to 3;
forming a silicon-containing resist middle layer film on the organic film by using a silicon-containing resist middle layer film material;
forming a resist upper layer film on the silicon-containing resist middle layer film by using a resist upper layer film material comprising a photoresist composition;
forming a circuit pattern in the resist upper layer film;
transferring the pattern to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further transferring the pattern to the body to be processed by etching while using the organic film having the transferred pattern as a mask.

6. A patterning process comprising:
forming an organic film on a body to be processed by using the composition for forming an organic film according to any one of claims 1 to 3;
forming a silicon-containing resist middle layer film on the organic film by using a silicon-containing resist middle layer film material;
forming an organic antireflective film or an adhesive film on the silicon-containing resist middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further transferring the pattern to the body to be processed by etching while using the organic film having the transferred pattern as a mask.

7. A patterning process comprising:
forming an organic film on a body to be processed by using the composition for forming an organic film according to any one of claims 1 to 3;
forming an inorganic hard mask middle layer film selected from a silicon oxide film, a silicon nitride film, and a silicon oxynitride film on the organic film;
forming a resist upper layer film on the inorganic hard mask middle layer film by using a resist upper layer film material comprising a photoresist composition;
forming a circuit pattern in the resist upper layer film;
transferring the pattern to the inorganic hard mask middle layer film by etching while using the resist upper layer film having the formed circuit pattern as a mask;
transferring the pattern to the organic film by etching while using the inorganic hard mask middle layer film having the transferred pattern as a mask; and
further transferring the pattern to the body to be processed by etching while using the organic film having the transferred pattern as a mask.

8. A patterning process comprising:
forming an organic film on a body to be processed by using the composition for forming an organic film according to any one of claims 1 to 3;
forming an inorganic hard mask middle layer film selected from a silicon oxide film, a silicon nitride film, and a silicon oxynitride film on the organic film;
forming an organic antireflective film or an adhesive film on the inorganic hard mask middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and the inorganic hard mask middle layer film by etching while using the resist upper layer film having the formed circuit pattern as a mask;
transferring the pattern to the organic film by etching while using the inorganic hard mask middle layer film having the transferred pattern as a mask; and
further transferring the pattern to the body to be processed by etching while using the organic film having the transferred pattern as a mask.

9. The patterning process according to claim 7 or 8, wherein the inorganic hard mask middle layer film is formed by a CVD method or an ALD method.

10. The patterning process according to any one of claims 5 to 9, wherein the circuit pattern is formed by a lithography using light having a wavelength of 10 nm or more and 300 nm or less, a direct writing with electron beam, nanoimprinting, or a combination thereof.

11. The patterning process according to any one of claims 5 to 10, wherein the circuit pattern is developed with an alkaline development or an organic solvent.

12. The patterning process according to any one of claims 5 to 11, wherein the body to be processed is a semiconductor device substrate or the semiconductor device substrate coated with any of a metal film, a metal carbide film, a metal oxide film, a metal nitride film, a metal oxycarbide film, and a metal oxynitride film.

13. The patterning process according to claim 12, wherein the metal constituting the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.
